# EUROPEAN PATENT APPLICATION

(11) **EP 4 641 826 A1**
(43) Date of publication of application: **29.10.2025**
(21) Application number: 23906471.0
(22) Date of filing: 27.10.2023
(51) Int. Cl.: H01P 1/185, H01F 19/04, H01F 21/12, H01F 27/00, H03H 11/16

(54) **DIGITAL PHASE SHIFTER**

(30) Priority: 20.12.2022 JP 2022203324
(71) Applicant: Fujikura Ltd., Tokyo 135-8512 (JP)
(72) Inventor: UEMICHI Yusuke, Sakura-shi, Chiba 285-8550 (JP)
(74) Representative: Lavoix
(86) International application number: PCT/JP2023/038933
(87) International publication number: WO 2024/135098

(57) **Abstract**

A digital phase shifter includes a first phase shift circuit of which a phase shift amount has frequency dependence, and a second phase shift circuit having frequency dependence of a phase shift amount that allows relaxation of the frequency dependence of the phase shift amount in the first phase shift circuit.

## Description

### TECHNICAL FIELD

The present invention relates to a digital phase shifter.

Priority is claimed on Japanese Patent Application No. 2022-203324 filed December 20, 2022, the content of which is incorporated herein by reference.

### BACKGROUND ART

In recent years, wireless communication using high-frequency signals such as microwaves, quasi-millimeter waves, millimeter waves, and the like has been attracting attention. In particular, in wireless communication at a frequency higher than a quasi-millimeter wave band, directivity of radio waves is increased, and thus beam forming is required, and a phase shifter for achieving the beam forming is indispensable.

For example, an example of a digital control type phase shifter (digital phase shifter) is disclosed in Non-Patent Document 1. The digital phase shifter includes a first circuit portion in which an inductor, a field-effect transistor (FET), and a series circuit including two capacitors are connected in parallel between a first port and a second port through which a high-frequency signal is input and output. Further, the digital phase shifter includes a second circuit portion in which an inductor and an FET are connected in parallel between a connection point of the two capacitors of the first circuit portion and a common return line.

In such a digital phase shifter, in a case in which the FET provided in the first circuit portion is set to a closed state, and the FET provided in the second circuit portion is set to an open state, a low-latency mode is obtained in which the delay of the phase of the high-frequency signal to be output is relatively small. On the other hand, in a case in which the FET provided in the first circuit portion is set to the open state, and the FET provided in the second circuit portion is set to the closed state, a high-latency mode is obtained in which the delay of the phase of the high-frequency signal to be output is relatively large.

### Citation List

### Non-Patent Document

Non-Patent Document 1: "Single-Ended and Differential Ka-Band BiCMOS Phased Array Front-Ends", IEEE Journal of Solid-State Circuits, Vol.43, No.10, October 2008

### SUMMARY OF INVENTION

### Technical Problem

In the digital phase shifter disclosed in Non-Patent Document 1, a difference (phase shift amount) between the phase in the low-latency mode and the phase in the high-latency mode has frequency dependence. Specifically, the phase shift amount decreases as the frequency decreases, and the phase shift amount increases as the frequency increases. In a case in which there is such frequency dependence, there is a possibility that a problem will occur in a case of handling the high-frequency signal having a wide frequency band.

The present invention has been made in view of the above-described circumstances, and an object of the present invention is to provide a digital phase shifter that can relax frequency dependence of a phase shift amount.

### Solution to Problem

A first aspect of the present invention relates to a digital phase shifter (PS1, PS2) including: a first phase shift circuit (100, 100A) of which a phase shift amount has frequency dependence, and a second phase shift circuit (200, 200A, 200B) having frequency dependence of a phase shift amount that allows relaxation of the frequency dependence of the phase shift amount in the first phase shift circuit.

The digital phase shifter according to the first aspect of the present invention includes the first phase shift circuit having the frequency dependence of the phase shift amount, and the second phase shift circuit having the frequency dependence of the phase shift amount that allows the relaxation of the frequency dependence of the phase shift amount in the first phase shift circuit. As a result, the frequency dependence of the phase shift amount in the first phase shift circuit can be relaxed.

A second aspect of the present invention relates to the digital phase shifter according to the first aspect of the present invention, in which the first phase shift circuit has the frequency dependence in which the phase shift amount increases as a frequency increases, and the second phase shift circuit has the frequency dependence in which the phase shift amount decreases as a frequency increases.

A third aspect of the present invention relates to the digital phase shifter according to the first or second aspect of the present invention, in which the second phase shift circuit includes a first circuit (210, 210B) connected between a first port (P200) and a second port (P210), a second circuit (220, 220A, 220B) connected in parallel to the first circuit, and a third circuit (230, 230A) connected between the second circuit and a common return line (LN0), and at least one of the first circuit, the second circuit, or the third circuit includes a variable inductor (ID1 to ID6).

A fourth aspect of the present invention relates to the digital phase shifter according to the third aspect of the present invention, in which the variable inductor (ID1 to ID3) includes a signal line (10), a first line (21) including a first parallel line (21p1) extending parallel to the signal line, a second line (22) including a second parallel line (22p2) extending parallel to the signal line, a first intersecting line (22c1) extending away from the signal line in an intersection direction intersecting a longitudinal direction of the signal line from a first end portion of the second parallel line, a third parallel line (22p3) extending parallel to the signal line from a first end portion of the first intersecting line, and a second intersecting line (22c2, 22c2') extending toward the signal line in the intersection direction from a first end portion of the third parallel line, a first ground conductor (31) electrically connected to a first end portion of the first parallel line and the first end portion of the second parallel line, a second ground conductor (32) connected to a first end portion of the second line, a first electronic switch (41) provided between a second end portion of the first parallel line and the second ground conductor, and a second electronic switch (42) provided between a second end portion of the second parallel line and the second ground conductor, and the signal line is located between the first parallel line and the second parallel line.

A fifth aspect of the present invention relates to the digital phase shifter according to the fourth aspect of the present invention, in which the second intersecting line (22c2') extends to intersect the second parallel line, the signal line, and the first parallel line in a plan view, and the second line further includes a fourth parallel line (22p4) extending parallel to the signal line from a first end portion of the second intersecting line, and a third intersecting line (22c3) extending toward the signal line in the intersection direction from a first end portion of the fourth parallel line.

A sixth aspect of the present invention relates to the digital phase shifter according to the fourth aspect of the present invention, in which the first line further includes a fourth intersecting line (21c1) extending away from the signal line in the intersection direction from the first end portion of the first parallel line, a fifth parallel line (21p2) extending parallel to the signal line from a first end portion of the fourth intersecting line, and a fifth intersecting line (21c2) extending toward the signal line in the intersection direction from a first end portion of the fifth parallel line.

A seventh aspect of the present invention relates to the digital phase shifter according to the third aspect of the present invention, in which the variable inductor (ID4 to ID6) includes a signal line (1), an inner line (2) including a first inner line (2a) provided on a first side of the signal line and a second inner line (2b) provided on a second side of the signal line, an outer line (3, 3a, 3b) provided at a position farther from the signal line than the inner line on at least one of the first side or the second side of the signal line, a first ground conductor (4a) connected to a first end portion of the first inner line, a first end portion of the second inner line, and a first end portion of the outer line, a second ground conductor (4b) connected to a second end portion of the outer line, a first electronic switch (7a) provided between a second end portion of the first inner line and the second ground conductor, and a second electronic switch (7b) provided between a second end portion of the second inner line and the second ground conductor.

An eighth aspect of the present invention relates to the digital phase shifter according to any one of the third to seventh aspects of the present invention, in which the first circuit includes a variable capacitor (211), the second circuit includes a circuit in which a first fixed inductor (221a) and a second fixed inductor (222a) are connected in series, and the third circuit includes a circuit in which the variable inductor and a fixed capacitor (231) are connected in series, and is connected to a connection point (Q) between the first fixed inductor and the second fixed inductor.

A ninth aspect of the present invention relates to the digital phase shifter according to any one of the third to seventh aspects of the present invention, in which the first circuit includes a variable capacitor (211), the second circuit includes a circuit in which a first variable inductor circuit (221A) in which a fixed inductor (221a) and a first variable inductor (221b) that is the variable inductor are connected in series and a second variable inductor circuit (222A) in which a fixed inductor (222a) and a second variable inductor (222b) that is the variable inductor are connected in series are connected in series, and the third circuit includes a circuit in which a variable capacitor (233) and a third variable inductor (232) that is the variable inductor are connected in series, and is connected to a connection point (Q) between the first variable inductor circuit and the second variable inductor circuit.

A tenth aspect of the present invention relates to the digital phase shifter according to any one of the third to seventh aspects of the present invention, in which the first circuit includes a fixed inductor (212), the second circuit includes a circuit in which a first variable capacitor (221c) and a second variable capacitor (222c) are connected in series, and the third circuit includes a circuit in which the variable inductor and a fixed capacitor (231) are connected in series, and is connected to a connection point (Q) between the first variable capacitor and the second variable capacitor.

An eleventh aspect of the present invention relates to the digital phase shifter according to any one of the first to tenth aspects of the present invention, in which the first phase shift circuit includes a plurality of digital phase shift circuits (300) that are cascade-connected, each of the plurality of digital phase shift circuits (300) includes a signal line (10), a first line (21) including a first parallel line (21p1) extending parallel to the signal line, a second line (22) including a second parallel line (22p2) extending parallel to the signal line, a first intersecting line (22c1) extending away from the signal line in an intersection direction intersecting a longitudinal direction of the signal line from a first end portion of the second parallel line, a third parallel line (22p3) extending parallel to the signal line from a first end portion of the first intersecting line, a second intersecting line (22c2') extending to intersect the second parallel line, the signal line, and the first parallel line in a plan view from a first end portion of the third parallel line, a fourth parallel line (22p4) extending parallel to the signal line from a first end portion of the second intersecting line, and a third intersecting line (22c3) extending toward the signal line in the intersection direction from a first end portion of the fourth parallel line, a first ground conductor (31) electrically connected to a first end portion of the first parallel line and the first end portion of the second parallel line, a second ground conductor (32) connected to a first end portion of the second line, a capacitor (60) connected to a first end portion of the signal line, a first electronic switch (41) provided between a second end portion of the first parallel line and the second ground conductor, a second electronic switch (42) provided between a second end portion of the second parallel line and the second ground conductor, and a third electronic switch (43) provided between the capacitor and the first ground conductor, and the signal line is located between the first parallel line and the second parallel line.

A twelfth aspect of the present invention relates to the digital phase shifter according to the eleventh aspect of the present invention, in which all of the first electronic switch and the second electronic switch provided in the digital phase shift circuit of the first phase shift circuit are controlled to be in a closed state or to be in an open state.

### Advantageous Effects of Invention

According to the above-described aspects of the present invention, it is possible to relax the frequency dependence of the phase shift amount.

### BRIEF DESCRIPTION OF DRAWINGS

[FIG. 1] A block diagram showing a configuration of a digital phase shifter according to a first embodiment of the present invention.
[FIG. 2] A circuit diagram showing a configuration of a first phase shift circuit in the first embodiment of the present invention.
[FIG. 3] A circuit diagram showing a configuration of a second phase shift circuit according to the first embodiment of the present invention.
[FIG. 4] A plan view showing a main configuration of a variable inductor according to the first embodiment of the present invention.
[FIG. 5] A cross-sectional view taken along a line II-II in FIG. 4.
[FIG. 6] A cross-sectional view taken along a line III-III in FIG. 4.
[FIG. 7A] A diagram showing a simulation result of the first phase shift circuit according to the first embodiment of the present invention.
[FIG. 7B] A diagram showing a simulation result of the second phase shift circuit in the first embodiment of the present invention.
[FIG. 8] A block diagram showing a configuration of a digital phase shifter according to a second embodiment of the present invention.
[FIG. 9] A plan view showing a main configuration of the digital phase shift circuit in the second embodiment of the present invention.
[FIG. 10] A cross-sectional view taken along a line II-II in FIG. 9.
[FIG. 11A] A diagram showing a simulation result of the first phase shift circuit in the second embodiment of the present invention.
[FIG. 11B] A diagram showing a simulation result of the first phase shift circuit in the second embodiment of the present invention.
[FIG. 12] A circuit diagram showing another configuration example of the second phase shift circuit in the first and second embodiments.
[FIG. 13] A circuit diagram showing another configuration example of the second phase shift circuit in the first and second embodiments.
[FIG. 14] A plan view showing another configuration example of the variable inductor.
[FIG. 15] A perspective view showing another configuration example of the variable inductor.
[FIG. 16] A perspective view showing another configuration example of the variable inductor.
[FIG. 17] A perspective view showing another configuration example of the variable inductor.

### DESCRIPTION OF EMBODIMENTS

Hereinafter, a digital phase shifter according to an embodiment of the present invention will be described in detail with reference to the drawings.

### [First Embodiment]

### <Digital Phase Shifter>

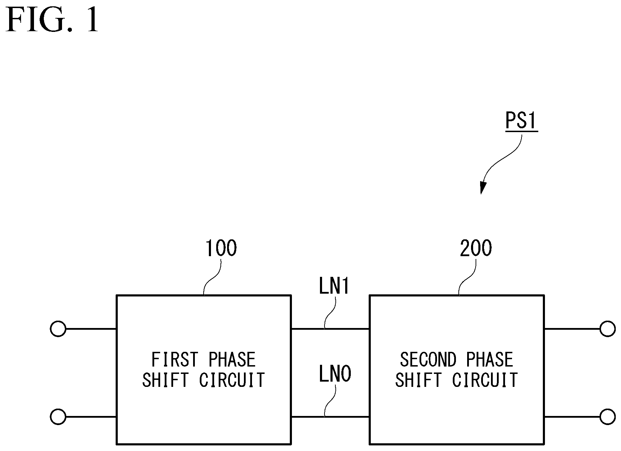

FIG. 1 is a block diagram showing a configuration of a digital phase shifter according to a first embodiment of the present invention. As shown in FIG. 1, a digital phase shifter PS1 of the present embodiment includes a first phase shift circuit 100 and a second phase shift circuit 200. The first phase shift circuit 100 and the second phase shift circuit 200 are cascade-connected via a signal line LN1 through which a high-frequency signal flows and a common return line LN0 (ground line). The digital phase shifter PS1 receives a high-frequency signal such as microwaves, quasi-millimeter waves, or millimeter waves as an input and outputs a high-frequency signal shifted by a predetermined phase to the outside.

The first phase shift circuit 100 shifts the input high-frequency signal by a predetermined phase and outputs the shifted high-frequency signal. The first phase shift circuit 100 has a phase shift amount having frequency dependence. For example, the first phase shift circuit 100 has the frequency dependence in which the phase shift amount increases as the frequency increases. The second phase shift circuit shifts the input high-frequency signal by a predetermined phase and outputs the shifted high-frequency signal, as in the first phase shift circuit 100. The second phase shift circuit 200 has frequency dependence of a phase shift amount that allows the relaxation of the frequency dependence of the phase shift amount in the first phase shift circuit 100. For example, the second phase shift circuit 200 has the frequency dependence in which the phase shift amount decreases as the frequency increases. As described above, the digital phase shifter PS1 of the present embodiment relaxes the frequency dependence of the phase shift amount of the first phase shift circuit 100 by the second phase shift circuit 200.

### <First Phase Shift Circuit>

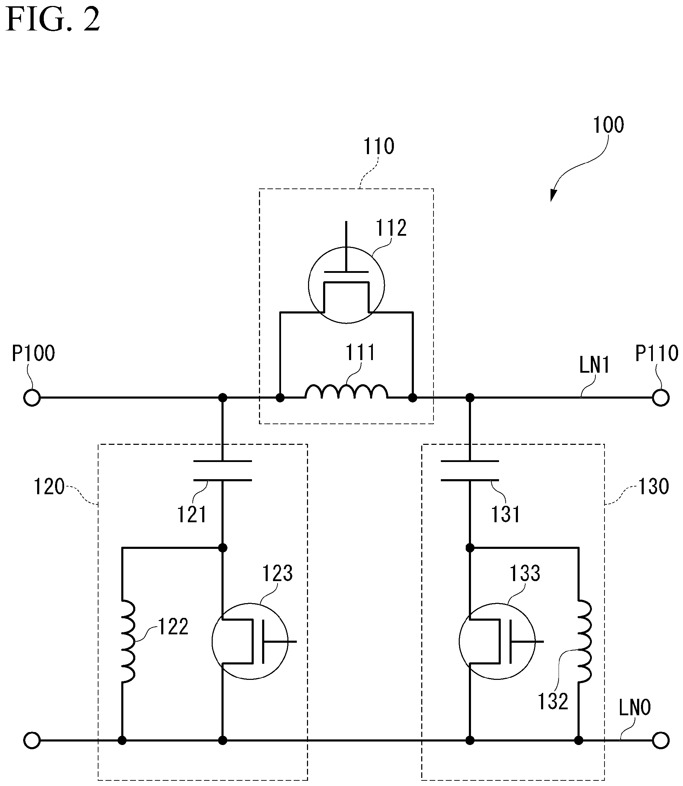

FIG. 2 is a circuit diagram showing a configuration of the first phase shift circuit in the first embodiment of the present invention. As shown in FIG. 2, the first phase shift circuit 100 includes a first circuit 110, a second circuit 120, and a third circuit 130. The first circuit 110 is connected between a first port P100 and a second port P110. The second circuit 120 is connected between the first port P100 and the common return line LN0, and the third circuit 130 is connected between the second port P110 and the common return line LN0. The first phase shift circuit 100 is a so-called π-type circuit.

The first phase shift circuit 100 has symmetry between the first port P100 and the second port P110. Therefore, in a case in which the high-frequency signal is input from the first port P100, the first phase shift circuit 100 outputs the high-frequency signal shifted by the predetermined phase from the second port P110 to the outside. In addition, in a case in which the high-frequency signal is input from the second port P110, the first phase shift circuit 100 outputs the high-frequency signal shifted by the predetermined phase from the first port P100 to the outside.

The first circuit 110 includes an inductor 111 and an electronic switch 112. The inductor 111 has a first end (one end) connected to the first port P100, and has a second end (the other end) connected to the second port P110. The electronic switch 112 is connected between both ends of the inductor 111, and opens or short-circuits between both ends of the inductor 111. As the electronic switch 112, for example, a field-effect transistor (FET) can be used.

The second circuit 120 includes a capacitor 121, an inductor 122, and an electronic switch 123. The capacitor 121 has a first electrode (one electrode) connected to the first port P100, and has a second electrode (the other electrode) connected to a first end (one end) of the inductor 122. The inductor 122 has the first end connected to the second electrode of the capacitor 121, and has a second end (the other end) connected to the common return line LN0. The electronic switch 123 is connected between both ends of the inductor 122, and opens or short-circuits between both ends of the inductor 122. As the electronic switch 123, for example, an FET can be used.

The third circuit 130 includes a capacitor 131, an inductor 132, and an electronic switch 133. The capacitor 131 has a first electrode (one electrode) connected to the second port P110, and has a second electrode (the other electrode) connected to a first end (one end) of the inductor 132. The inductor 132 has the first end connected to the second electrode of the capacitor 131, and has a second end (the other end) connected to the common return line LN0. The electronic switch 133 is connected between both ends of the inductor 132, and opens or short-circuits between both ends of the inductor 132. As the electronic switch 133, for example, an FET can be used.

The electronic switch 112 of the first circuit 110, the electronic switch 123 of the second circuit 120, and the electronic switch 133 of the third circuit 130 are controlled by a control unit (not shown) in a case in which the phase shift amount of the first phase shift circuit 100 is changed. Specifically, in a case in which the first phase shift circuit 100 is set to a low-latency mode, the electronic switch 112 of the first circuit 110 is controlled to be in a closed state, and the electronic switch 123 of the second circuit 120 and the electronic switch 133 of the third circuit 130 are controlled to be in an open state. On the other hand, in a case in which the first phase shift circuit 100 is set to a high-latency mode, the electronic switch 112 of the first circuit 110 is controlled to be in the open state, and the electronic switch 123 of the second circuit 120 and the electronic switch 133 of the third circuit 130 are controlled to be in the closed state. The low-latency mode is a mode in which the delay of the high-frequency signal output from the first phase shift circuit 100 is relatively small, and the high-latency mode is a mode in which the delay of the high-frequency signal output from the first phase shift circuit 100 is relatively large.

In the above-described configuration, in a case in which the electronic switch 112 of the first circuit 110 is in the closed state and the electronic switch 123 of the second circuit 120 and the electronic switch 133 of the third circuit 130 are in the open state under the control of the control unit (not shown), the first phase shift circuit 100 is in the low-latency mode. As a result, the phase of the high-frequency signal output from the first phase shift circuit 100 is φₓ₁. On the other hand, in a case in which the electronic switch 112 of the first circuit 110 is in the open state and the electronic switch 123 of the second circuit 120 and the electronic switch 133 of the third circuit 130 are in the closed state under the control of the control unit (not shown), the first phase shift circuit 100 is in the high-latency mode. As a result, the phase of the high-frequency signal output from the first phase shift circuit 100 is φ_{y1}. In this way, the control unit (not shown) controls the phase shift amount (a difference between the phase φₓ₁ and the phase φ_{y1}) of the first phase shift circuit 100.

### <Second Phase Shift Circuit>

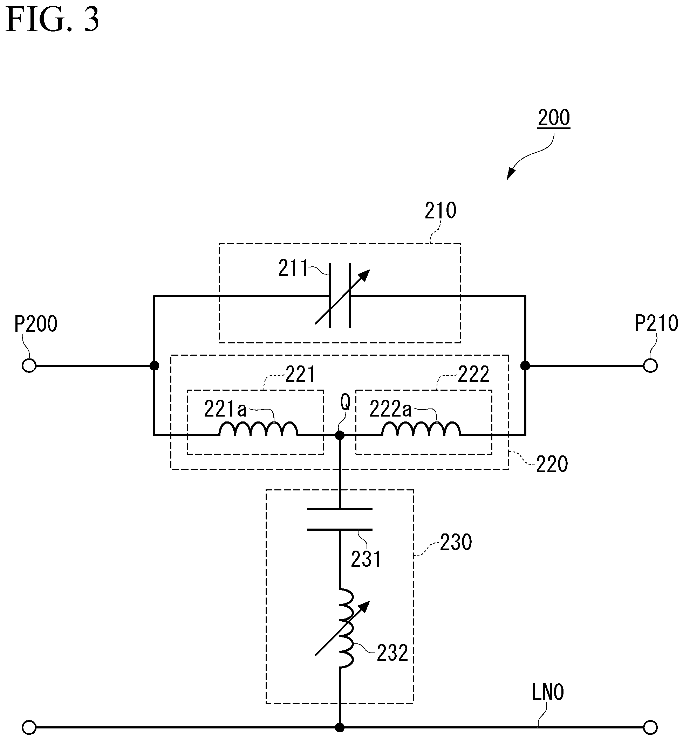

FIG. 3 is a circuit diagram showing a configuration of the second phase shift circuit in the first embodiment of the present invention. As shown in FIG. 3, the second phase shift circuit 200 includes a first circuit 210, a second circuit 220, and a third circuit 230. The first circuit 210 and the second circuit 220 are connected between a first port P200 and a second port P210. The first circuit 210 and the second circuit 220 are connected in parallel to each other. The third circuit 230 is connected between the second circuit 220 and the common return line LN0. The second phase shift circuit 200 receives a high-frequency signal such as microwaves, quasi-millimeter waves, or millimeter waves as an input and outputs a high-frequency signal shifted by a predetermined phase to the outside.

The second phase shift circuit 200 has symmetry between the first port P200 and the second port P210. Therefore, in a case in which the high-frequency signal is input from the first port P200, the second phase shift circuit 200 outputs the high-frequency signal shifted by the predetermined phase from the second port P210 to the outside. In addition, in a case in which the high-frequency signal is input from the second port P210, the second phase shift circuit 200 outputs the high-frequency signal shifted by the predetermined phase from the first port P200 to the outside.

The first circuit 210 includes a variable capacitor 211. The variable capacitor 211 has a first electrode (one electrode) connected to the first port P200, and has a second electrode (the other electrode) connected to the second port P210. The variable capacitor 211 is controlled by the control unit (not shown) in a case in which the phase shift amount of the second phase shift circuit 200 is changed.

The second circuit 220 includes a first fixed inductor circuit 221 and a second fixed inductor circuit 222 that are connected in series. The first fixed inductor circuit 221 includes a fixed inductor 221a (first fixed inductor), and the second fixed inductor circuit 222 includes a fixed inductor 222a (second fixed inductor). The fixed inductor 221a has a first end (one end) connected to the first port P200, and has a second end (the other end) connected to a first end (one end) of the fixed inductor 222a. The fixed inductor 222a has the first end connected to the second end of the fixed inductor 221a, and has a second end (the other end) connected to the second port P210.

The third circuit 230 includes a capacitor 231 (fixed capacitor) and a variable inductor 232 that are connected in series, and is connected to a connection point Q between the first fixed inductor circuit 221 and the second fixed inductor circuit 222 that are provided in the second circuit 220. The capacitor 231 has a first electrode (one electrode) connected to the connection point Q, and has a second electrode (the other electrode) connected to a first end (one end) of the variable inductor 232. The variable inductor 232 has the first end connected to the second electrode of the capacitor 231, and has a second end (the other end) connected to the common return line LN0. Similar to the variable capacitor 211, the variable inductor 232 is controlled by the control unit (not shown) in a case in which the phase shift amount of the second phase shift circuit 200 is changed. The details of the variable inductor 232 will be described below.

In the above-described configuration, the control unit (not shown) controls the variable capacitor 211 and the variable inductor 232 to change the magnitude of the capacitance of the variable capacitor 211 and the magnitude of the inductance of the variable inductor 232, so that the phase shift amount of the second phase shift circuit 200 is changed. For example, in a case in which the control unit (not shown) sets the capacitance of the variable capacitor 211 to Cₓ and sets the inductance of the variable inductor 232 to Lₓ, the phase of the high-frequency signal output from the second phase shift circuit 200 is φₓ₂. In addition, for example, in a case in which a control unit (not shown) sets the capacitance of the variable capacitor 211 to C_{y} and sets the inductance of the variable inductor 232 to L_{y}, the phase of the high-frequency signal output from the second phase shift circuit 200 is φ_{y2}. In this way, the control unit (not shown) controls the phase shift amount (a difference between the phase φx₂ and the phase φ_{y2}) of the second phase shift circuit 200.

### <Variable Inductor>

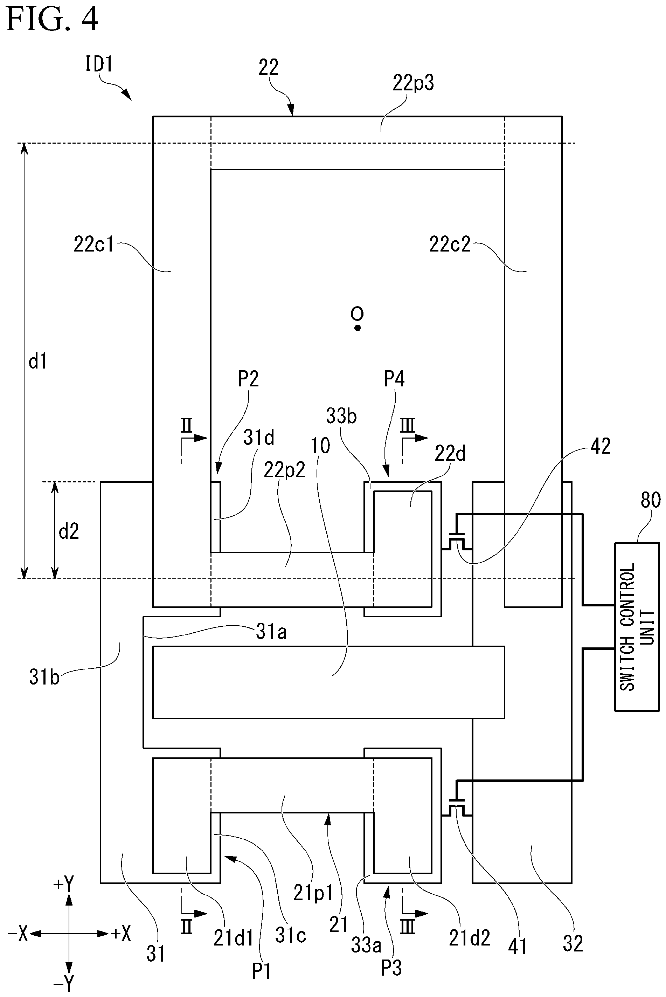

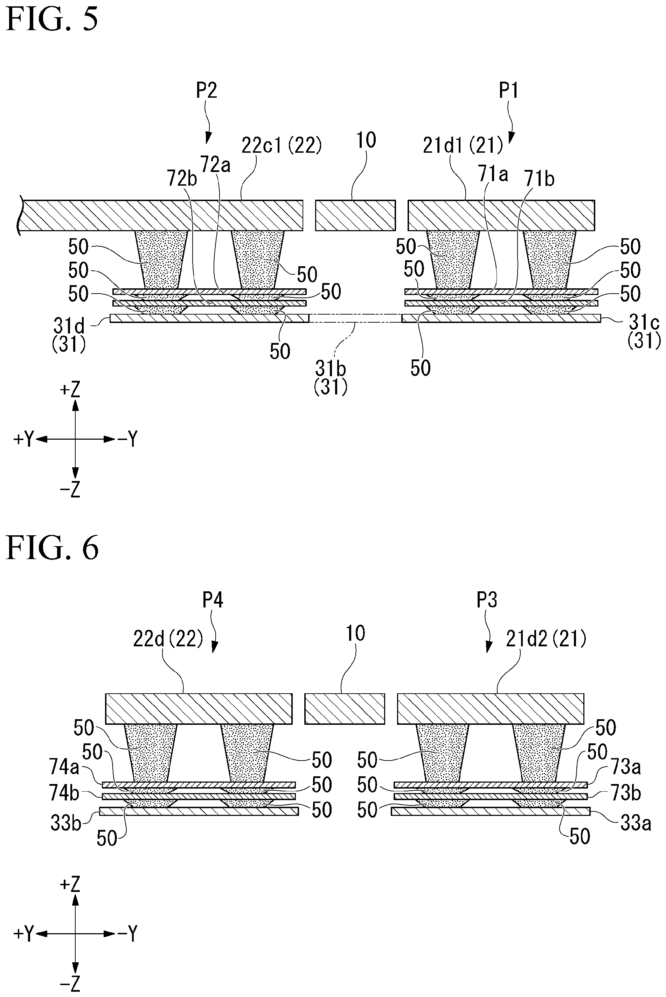

FIG. 4 is a plan view showing a main configuration of the variable inductor in the first embodiment of the present invention. FIG. 5 is a cross-sectional view taken along a line II-II in FIG. 4. FIG. 6 is a cross-sectional view taken along a line III-III in FIG. 4. A variable inductor ID1 having the configuration shown in FIGS. 4 to 6 is used as the variable inductor 232 shown in FIG. 3.

As shown in FIG. 4, the variable inductor ID1 includes a signal line 10, a first line 21, a second line 22, a first ground conductor 31, and a second ground conductor 32. The first line 21 in the present embodiment includes a first parallel line 21p1 and a pair of upper pads 21d1 and 21d2. The second line 22 in the present embodiment includes a second parallel line 22p2, a first intersecting line 22c1, a third parallel line 22p3, a second intersecting line 22c2, and an upper pad 22d. In addition, the variable inductor ID1 in the present embodiment includes the first electronic switch 41 and the second electronic switch 42, a plurality of connection conductors 50, and a plurality of connection pads P1 to P4 (see also FIGS. 5 and 6).

As shown in FIG. 4, the signal line 10 is a linear strip-shaped conductor extending in one direction. That is, the signal line 10 is an elongated plate-shaped conductor having a constant width, a constant thickness, and a predetermined length. In the signal line 10, a signal current flows from a left side of a paper surface to a right side of the paper surface in FIG. 4, that is, from an end portion (input end) on the left side of the paper surface to an end portion (output end) on the right side of the paper surface. This signal current is a high-frequency signal having a wavelength range of the microwaves, the quasi-millimeter waves, or the millimeter waves described above. For example, the signal line 10 has an input end connected to a second electrode of the capacitor 231 shown in FIG. 3, and has an output end connected to the common return line LN0 shown in FIG. 1.

Here, in the present embodiment, a longitudinal direction of the signal line 10 (a direction in which the signal line 10 extends) will be simply referred to as a longitudinal direction X. A direction from the input end to the output end of the signal line 10 along the longitudinal direction X will be referred to as a +X direction or a right side. A direction opposite to the right side will be referred to as a left side or a -X direction. A direction intersecting (for example, orthogonal to) the signal line 10 will be referred to as an intersection direction Y. One direction along the intersection direction Y will be referred to as a rear side or a +Y direction. A direction opposite to the rear side will be referred to as a front side or a -Y direction. A direction intersecting (for example, orthogonal to) both the longitudinal direction X and the intersection direction Y will be referred to as an up-down direction Z. One direction along the up-down direction Z will be referred to as an upper side or a +Z direction. A direction opposite to the upper side will be referred to as a lower side or a -Z direction. Viewing in the up-down direction Z will be referred to as a plan view.

In addition, the up-down direction Z need not coincide with a vertical direction. In addition, the "upper side" and the "lower side" need not coincide with an upper side and a lower side in the vertical direction. In addition, the +X direction and the -X direction may be defined as a left side and a right side instead of defining the +X direction and the -X direction as a right side and a left side.

The signal line 10 has, electrically, an inductance L1 as a concentrated constant circuit. The inductance L1 is a parasitic inductance having magnitude corresponding to a shape of the signal line 10, such as a length of the signal line 10.

In the following description, one side (+Y side) of the signal line 10 in the Y direction will be referred to as a first side of the signal line 10, and the other side (-Y side) of the signal line 10 in the Y direction will be referred to as a second side of the signal line 10. The first parallel line 21p1 is a linear strip-shaped conductor provided on the second side (-Y side) of the signal line 10. The first parallel line 21p1 is an elongated plate-shaped conductor having a constant width, a constant thickness, and a predetermined length. The first parallel line 21p1 extends parallel to the signal line 10 (in the longitudinal direction X). The first parallel line 21p1 and the signal line 10 are disposed with a spacing in the intersection direction Y. Among the ends of the first parallel line 21p1, an end located on the -X side will be referred to as a first end (one end), and an end located on the +X side will be referred to as a second end (the other end). Among the side edges of the first parallel line 21p1, a side edge located on the +Y side will be referred to as a first side edge (one side edge), and a side edge located on the -Y side will be referred to as a second side edge (the other side edge).

The upper pad 21d1 is a rectangular flat plate conductor connected to the first end (-X side) of the first parallel line 21p1. Long sides of the upper pad 21d1 extend in the intersection direction Y, and short sides of the upper pad 21d1 extend in the longitudinal direction X. Among the short sides of the upper pad 21d1, a short side located on the +Y side will be referred to as a first short side (one short side), and a short side located on the -Y side will be referred to as a second short side (the other short side). The first short side (+Y side) of the upper pad 21d1 is located at substantially the same position as the first side edge (+Y side) of the first parallel line 21p1. In addition, the second short side (-Y side) of the upper pad 21d1 is located on the front side (-Y side) with respect to the second side edge (-Y side) of the first parallel line 21p1. That is, a dimension of the upper pad 21d1 in the intersection direction Y is greater than a width (a dimension in the intersection direction Y) of the first parallel line 21p1.

The upper pad 21d2 is a rectangular flat plate conductor connected to the second end (+X side) of the first parallel line 21p1. Long sides of the upper pad 21d2 extend in the intersection direction Y, and short sides of the upper pad 21d2 extend in the longitudinal direction X. Among the short sides of the upper pad 21d2, a short side located on the +Y side will be referred to as a first short side (one short side), and a short side located on the -Y side will be referred to as a second short side (the other short side). The first short side (+Y side) of the upper pad 21d2 is located at substantially the same position as the first side edge (+Y side) of the first parallel line 21p1. In addition, the second short side (-Y side) of the upper pad 21d2 is located on the front side (-Y side) with respect to the second side edge (-Y side) of the first parallel line 21p1. That is, a dimension of the upper pad 21d2 in the intersection direction Y is greater than a width (a dimension in the intersection direction Y) of the first parallel line 21p1.

The second parallel line 22p2 is a linear strip-shaped conductor provided on the first side (+Y side) of the signal line 10. The second parallel line 22p2 is an elongated plate-shaped conductor having a constant width, a constant thickness, and a predetermined length. The second parallel line 22p2 extends parallel to the signal line 10 (in the longitudinal direction X). The second parallel line 22p2 and the signal line 10 are disposed with a spacing in the intersection direction Y. Among the ends of the second parallel line 22p2, an end located on the -X side will be referred to as a first end (one end), and an end located on the +X side will be referred to as a second end (the other end). Among the side edges of the second parallel line 22p2, a side edge located on the -Y side will be referred to as a first side edge (one side edge), and a side edge located on the +Y side will be referred to as a second side edge (the other side edge).

The second parallel line 22p2 is provided on an opposite side to the first parallel line 21p1 with respect to the signal line 10. In other words, the second parallel line 22p2 is disposed such that the signal line 10 is located between the first parallel line 21p1 and the second parallel line 22p2 in the intersection direction Y.

The first intersecting line 22c1 is a linear strip-shaped conductor connected to the first end (-X side) of the second parallel line 22p2. The first intersecting line 22c1 is an elongated plate-shaped conductor having a constant width, a constant thickness, and a predetermined length. The first intersecting line 22c1 extends away from the signal line 10 from the first end (-X side) of the second parallel line 22p2 in the intersection direction Y. That is, the first intersecting line 22c1 in the present embodiment extends toward the rear side (+Y side) from the first end (-X side) of the second parallel line 22p2. An end edge (-Y side) of the first intersecting line 22c1 on the front side is located at substantially the same position as the first side edge (-Y side) of the second parallel line 22p2. Among the ends of the first intersecting line 22c1, an end located on the +Y side will be referred to as a first end (one end), and an end located on the -Y side will be referred to as a second end (the other end).

The upper pad 22d is a rectangular flat plate conductor connected to the second end (+X side) of the second parallel line 22p2. Long sides of the upper pad 22d extend in the intersection direction Y, and short sides of the upper pad 22d extend in the longitudinal direction X. Among the short sides of the upper pad 22d, a short side located on the -Y side will be referred to as a first short side (one short side), and a short side located on the +Y side will be referred to as a second short side (the other short side). The first short side (-Y side) of the upper pad 22d is located at substantially the same position as the first side edge (-Y side) of the second parallel line 22p2. In addition, the second short side (+Y side) of the upper pad 22d is located on the rear side (+Y side) with respect to the second side edge (+Y side) of the second parallel line 22p2. That is, a dimension of the upper pad 22d in the intersection direction Y is greater than a width (dimension in the intersection direction Y) of the second parallel line 22p2.

The third parallel line 22p3 is a linear strip-shaped conductor connected to the first end (+Y end) of the first intersecting line 22c1. The third parallel line 22p3 is an elongated plate-shaped conductor having a constant width, a constant thickness, and a predetermined length. The third parallel line 22p3 extends parallel to the signal line 10 (in the longitudinal direction X) from the first end (+Y side) of the first intersecting line 22c1. That is, the third parallel line 22p3 in the present embodiment extends toward the right side (+X side) from the first end (+Y side) of the first intersecting line 22c1. Among the ends of the third parallel line 22p3, an end located on the +X side will be referred to as a first end (one end), and an end located on the -X side will be referred to as a second end (the other end).

The third parallel line 22p3 is provided at a position farther from the signal line 10 than the second parallel line 22p2 on the first side (+Y side) of the signal line 10. In other words, the third parallel line 22p3 is disposed such that the second parallel line 22p2 is located between the signal line 10 and the third parallel line 22p3 in the intersection direction Y.

As shown in FIG. 4, in the intersection direction Y, a distance d1 between a center line of the second parallel line 22p2 and a center line of the third parallel line 22p3 is greater than a distance d2 between the center line of the second parallel line 22p2 and the outer edge (an outer edge on the third parallel line 22p3 side) on the rear side of the first ground conductor 31. In addition, a right end of the third parallel line 22p3 (that is, the first end (+X side) of the third parallel line 22p3) is located on the right side (+X side) with respect to the long side of the upper pad 22d of the second line 22 on the right side (+X side).

The second intersecting line 22c2 is a linear strip-shaped conductor connected to the first end (+X side) of the third parallel line 22p3. The second intersecting line 22c2 is an elongated plate-shaped conductor having a constant width, a constant thickness, and a predetermined length. The second intersecting line 22c2 extends toward the signal line 10 in the intersection direction Y from the first end (+X side) of the third parallel line 22p3. That is, the second intersecting line 22c2 in the present embodiment extends toward the front side (-Y side) from the first end (+X side) of the third parallel line 22p3. Among the ends of the second intersecting line 22c2, an end located on the -Y side will be referred to as a first end (one end), and an end located on the +Y side will be referred to as a second end (the other end).

A first end edge (-Y side) of the second intersecting line 22c2 in the present embodiment is located at substantially the same position as the first short side (-Y side) of the upper pad 22d and the first side edge (-Y side) of the second parallel line 22p2. In addition, the upper pad 22d and the second intersecting line 22c2 are disposed with a spacing in the longitudinal direction X. In addition, a left side edge (-X side) of the second intersecting line 22c2 in the present embodiment is located at substantially the same position as a right end edge (+X side) of the signal line 10.

In addition, the first end (-Y side) of the second intersecting line 22c2 in the present embodiment is always electrically connected to the second ground conductor 32 by a conductor (not shown). In other words, one end of the second line 22 is always electrically connected to the second ground conductor 32 by a conductor (not shown).

The first intersecting line 22c1, the third parallel line 22p3, and the second intersecting line 22c2 described above constitute a loop line that is looped in a U-shape to be convex toward the rear side (+Y side).

The first ground conductor 31 is a plate-shaped conductor that is provided on the input end side (-X side) of the signal line 10. The first ground conductor 31 is electrically grounded. In addition, a rectangular notch 31a is formed on a side edge of the first ground conductor 31 on the right side (+X side). In the present embodiment, the notch 31a is formed, so that the first ground conductor 31 and the signal line 10 do not overlap each other in the longitudinal direction X.

In addition, in the present embodiment, a portion of the first ground conductor 31 located on the left side (-X side) with respect to the notch 31a will be referred to as a "base portion 31b", a portion of the first ground conductor 31 located on the front side (-Y side) with respect to the notch 31a will be referred to as a "first protrusion portion 31c", and a portion of the first ground conductor 31 located on the rear side (+Y side) with respect to the notch 31a will be referred to as a "second protrusion portion 31d". Each of the first protrusion portion 31c and the second protrusion portion 31d protrudes toward the right side (+X side) from the base portion 31b. The first ground conductor 31 need not be formed with the notch 31a, the first protrusion portion 31c, and the second protrusion portion 31d. For example, the shape of the first ground conductor 31 in a plan view may be a rectangular shape.

Each of the first protrusion portion 31c and the second protrusion portion 31d has a rectangular shape in which long sides extend in the intersection direction Y and short sides extend in the longitudinal direction X. The first protrusion portion 31c overlaps the upper pad 21d1 in the up-down direction Z. The second protrusion portion 31d overlaps an end portion of the first intersecting line 22c1 on the front side (-Y side) in the up-down direction Z. As shown in FIG. 5, the first ground conductor 31 is located below the signal line 10, the first line 21 (upper pad 21d1), and the second line 22 (first intersecting line 22c1).

The second ground conductor 32 is a plate-shaped conductor that is provided on the output end side (+X side) of the signal line 10. The second ground conductor 32 is electrically grounded. Although detailed illustration is omitted, the second ground conductor 32 is located below the signal line 10 and the second line 22 (second intersecting line 22c2).

As shown in FIG. 5, a first connection pad P1 includes the upper pad 21d1 described above, an upper intermediate pad 71a, a lower intermediate pad 71b, and the first protrusion portion 31c described above. The upper pad 21d1, the upper intermediate pad 71a, the lower intermediate pad 71b, and the first protrusion portion 31c overlap each other in a plan view. In addition, the upper pad 21d1, the upper intermediate pad 71a, the lower intermediate pad 71b, and the first protrusion portion 31c are arranged in this order from the upper side (+Z side) to the lower side (-Z side) and are disposed with spacings in the up-down direction Z.

Although detailed illustration is omitted, the upper pad 21d1, the upper intermediate pad 71a, the lower intermediate pad 71b, and the first protrusion portion 31c in the present embodiment have substantially the same shape as each other. That is, the positions and the dimensions of the upper pad 21d1, the upper intermediate pad 71a, the lower intermediate pad 71b, and the first protrusion portion 31c in the longitudinal direction X and the intersection direction Y are substantially the same as each other. In FIG. 4, the dimensions of the first protrusion portion 31c are shown to be large to improve visibility of each component.

As shown in FIG. 5, the upper pad 21d1 and the upper intermediate pad 71a are electrically and mechanically connected to each other through a plurality of connection conductors 50. In addition, the upper intermediate pad 71a and the lower intermediate pad 71b are electrically and mechanically connected to each other through the plurality of connection conductors 50. In addition, the lower intermediate pad 71b and the first protrusion portion 31c are electrically and mechanically connected to each other through the plurality of connection conductors 50. As a result, the first connection pad P1 is always electrically connected to the first end (-X side) of the first parallel line 21p1 and the first ground conductor 31.

In the present specification, the "connection conductor 50" is a conductor extending in the up-down direction Z, and is a member that electrically and mechanically connects a member connected to an upper end of the connection conductor 50 and a member connected to a lower end of the connection conductor 50. The connection conductor 50 is, for example, a via that penetrates an insulating layer (not shown) in the up-down direction Z.

As shown in FIG. 5, a second connection pad P2 includes an end portion of the first intersecting line 22c1 described above on the front side (-Y side), an upper intermediate pad 72a, a lower intermediate pad 72b, and the second protrusion portion 31d described above. The end portion of the first intersecting line 22c1 on the front side (-Y side), the upper intermediate pad 72a, the lower intermediate pad 72b, and the second protrusion portion 31d overlap each other in a plan view. In addition, the end portion of the first intersecting line 22c1 on the front side (-Y side), the upper intermediate pad 72a, the lower intermediate pad 72b, and the second protrusion portion 31d are arranged in this order from the upper side (+Z side) to the lower side (-Z side) and are disposed with spacings in the up-down direction Z.

Although detailed illustration is omitted, the upper intermediate pad 72a, the lower intermediate pad 72b, and the second protrusion portion 31d in the present embodiment have substantially the same shape as each other. That is, the positions and the dimensions of the upper intermediate pad 72a, the lower intermediate pad 72b, and the second protrusion portion 31d in the longitudinal direction X and the intersection direction Y are substantially the same as each other. In FIG. 4, the dimensions of the second protrusion portion 31d are shown to be large to improve visibility of each component.

As shown in FIG. 5, the end portion of the first intersecting line 22c1 on the front side (-Y side) and the upper intermediate pad 72a are electrically and mechanically connected to each other through the plurality of connection conductors 50. In addition, the upper intermediate pad 72a and the lower intermediate pad 72b are electrically and mechanically connected to each other through the plurality of connection conductors 50. In addition, the lower intermediate pad 72b and the second protrusion portion 31d are electrically and mechanically connected to each other through the plurality of connection conductors 50. As a result, the second connection pad P2 is always electrically connected to the first end (-X side) of the second parallel line 22p2 and the first ground conductor 31.

As shown in FIG. 6, a third connection pad P3 includes the upper pad 21d2 described above, an upper intermediate pad 73a, a lower intermediate pad 73b, and a lower pad 33a. The upper pad 21d2, the upper intermediate pad 73a, the lower intermediate pad 73b, and the lower pad 33a overlap each other in a plan view. In addition, the upper pad 21d2, the upper intermediate pad 73a, the lower intermediate pad 73b, and the lower pad 33a are arranged in this order from the upper side (+Z side) to the lower side (-Z side) and are disposed with spacings in the up-down direction Z.

Here, as shown in FIG. 4, the lower pad 33a is a rectangular flat plate conductor in which long sides extend in the intersection direction Y and short sides extend in the longitudinal direction X. The lower pad 33a is provided separately from the second ground conductor 32. The presence or absence of the electrical connection between the lower pad 33a and the second ground conductor 32 is switched depending on a state of a first electronic switch 41. Accordingly, the presence or absence of the electrical grounding of the lower pad 33a is switched depending on the state of the first electronic switch 41.

Although detailed illustration is omitted, the upper pad 21d2, the upper intermediate pad 73a, the lower intermediate pad 73b, and the lower pad 33a in the present embodiment have substantially the same shape as each other. That is, the positions and the dimensions of the upper pad 21d2, the upper intermediate pad 73a, the lower intermediate pad 73b, and the lower pad 33a in the longitudinal direction X and the intersection direction Y are substantially the same as each other. **In** FIG. 4, the dimensions of the lower pad 33a are shown to be large to improve visibility of each component.

As shown in FIG. 6, the upper pad 21d2 and the upper intermediate pad 73a are electrically and mechanically connected to each other through a plurality of connection conductors 50. In addition, the upper intermediate pad 73a and the lower intermediate pad 73b are electrically and mechanically connected to each other through the plurality of connection conductors 50. In addition, the lower intermediate pad 73b and the lower pad 33a are electrically and mechanically connected to each other through the plurality of connection conductors 50. As a result, the third connection pad P3 is always electrically connected to the second end (+X side) of the first parallel line 21p1 and the first electronic switch 41.

As shown in FIG. 6, a fourth connection pad P4 includes the upper pad 22d described above, an upper intermediate pad 74a, a lower intermediate pad 74b, and a lower pad 33b. The upper pad 22d, the upper intermediate pad 74a, the lower intermediate pad 74b, and the lower pad 33b overlap each other in a plan view. In addition, the upper pad 22d, the upper intermediate pad 74a, the lower intermediate pad 74b, and the lower pad 33b are arranged in this order from the upper side (+Z side) to the lower side (-Z side) and are disposed with spacings in the up-down direction Z.

Here, as shown in FIG. 4, the lower pad 33b is a rectangular flat plate conductor in which long sides extend in the intersection direction Y and short sides extend in the longitudinal direction X. The lower pad 33b is provided separately from the second ground conductor 32 and the lower pad 33a. The presence or absence of the electrical connection between the lower pad 33b and the second ground conductor 32 is switched depending on a state of a second electronic switch 42. Accordingly, the presence or absence of the electrical grounding of the lower pad 33b is switched depending on the state of the second electronic switch 42.

Although detailed illustration is omitted, the upper pad 22d, the upper intermediate pad 74a, the lower intermediate pad 74b, and the lower pad 33b in the present embodiment have substantially the same shape as each other. That is, the positions and the dimensions of the upper pad 22d, the upper intermediate pad 74a, the lower intermediate pad 74b, and the lower pad 33b in the longitudinal direction X and the intersection direction Y are substantially the same as each other. In FIG. 4, the dimensions of the lower pad 33b are shown to be large to improve visibility of each component.

Here, as described above, the dimension of the upper pad 22d in the intersection direction Y is greater than the width (the dimension in the intersection direction Y) of the second parallel line 22p2 (see also FIG. 4). Therefore, the maximum value of the dimension of the fourth connection pad P4 in the intersection direction Y is greater than the width (the dimension in the intersection direction Y) of the second parallel line 22p2.

In addition, as described above, the first end edge (-Y side) of the second intersecting line 22c2 in the present embodiment is located at substantially the same position as the first short side (-Y side) of the upper pad 22d (see also FIG. 4). Accordingly, at least part of the second intersecting line 22c2 and at least part (in the present embodiment, the entirety) of the fourth connection pad P4 face each other in the longitudinal direction X.

As shown in FIG. 4, the first electronic switch 41 is a transistor that openably and closably connects the lower pad 33a of the third connection pad P3 and the second ground conductor 32. As shown in FIG. 4, the first electronic switch 41 in the present embodiment is, for example, a MOS type FET, in which a drain terminal is connected to the lower pad 33a of the third connection pad P3, a source terminal is connected to the second ground conductor 32, and a gate terminal is connected to the switch control unit 80.

The first electronic switch 41 switches the conduction state between the drain terminal and the source terminal between the open state and the closed state based on a gate signal input to the gate terminal from the switch control unit 80. That is, the first electronic switch 41 switches the conduction state and the cut-off state between the second end (+X side) of the first parallel line 21p1 and the second ground conductor 32 by the switch control unit 80.

As shown in FIG. 4, the second electronic switch 42 is a transistor that openably and closably connects the lower pad 33b of the fourth connection pad P4 and the second ground conductor 32. As shown in FIG. 4, the second electronic switch 42 in the present embodiment is, for example, a MOS type FET, in which a drain terminal is connected to the lower pad 33b of the fourth connection pad P4, a source terminal is connected to the second ground conductor 32, and a gate terminal is connected to the switch control unit 80.

The second electronic switch 42 switches the conduction state between the drain terminal and the source terminal between the open state and the closed state based on a gate signal input to the gate terminal from the switch control unit 80. That is, the second electronic switch 42 switches the conduction state and the cut-off state between the second end (+X side) of the second parallel line 22p2 and the second ground conductor 32 by the switch control unit 80.

The switch control unit 80 is a control circuit that controls the first electronic switch 41 and the second electronic switch 42. The switch control unit 80 includes two output ports, and individually outputs the gate signals to the gate terminals of the first electronic switch 41 and the second electronic switch 42 from the output ports. That is, the switch control unit 80 controls the first electronic switch 41 and the second electronic switch 42 between the open state or the closed state by the gate signal. The switch control unit 80 is provided in the control unit (not shown) that controls the variable capacitor 211 and the variable inductor 232 shown in FIG. 3 to change the phase shift amount of the second phase shift circuit 200.

Next, the operations of the variable inductor ID1 configured as described above will be described.

In the variable inductor ID1 in the present embodiment, the operation mode is switched depending on the conduction states of the first electronic switch 41 and the second electronic switch 42. That is, the operation mode of the variable inductor ID1 includes a low-inductance mode in which the first electronic switch 41 and the second electronic switch 42 are set to the closed state by the switch control unit 80, and a high-inductance mode in which the first electronic switch 41 and the second electronic switch 42 are set to the open state by the switch control unit 80.

In the low-inductance mode, the switch control unit 80 sets the first electronic switch 41 and the second electronic switch 42 to the closed state.

By setting the first electronic switch 41 to the closed state, the second end (+X side) of the first parallel line 21p1 is connected to the second ground conductor 32 through the third connection pad P3 (see FIG. 4). On the other hand, the first end (-X side) of the first parallel line 21p1 is always connected to the first ground conductor 31 through the first connection pad P1 (see FIGS. 4 and 5). Therefore, the first parallel line 21p1 forms a first current path in which the current can flow between the first end (-X side) and the second end (+X side) by connecting the second end (+X side) to the second ground conductor 32 through the first electronic switch 41.

In addition, by setting the second electronic switch 42 to the closed state, the second end (+X side) of the second parallel line 22p2 is connected to the second ground conductor 32 through the fourth connection pad P4 (see FIG. 4). On the other hand, the first end (-X side) of the second parallel line 22p2 is always connected to the first ground conductor 31 through the second connection pad P2 (see FIGS. 4 and 5). Therefore, the second parallel line 22p2 forms a second current path in which the current can flow between the first end (-X side) and the second end (+X side) by connecting the second end (+X side) to the second ground conductor 32 through the second electronic switch 42.

In a state in which both ends of the first parallel line 21p1 and the second parallel line 22p2 are connected to each other, when a signal current flows from the input end toward the output end in the signal line 10, a return current is generated in the first parallel line 21p1 and the second parallel line 22p2 due to the propagation of the signal current. The return current flows through the first parallel line 21p1 and the second parallel line 22p2 from the second end (+X side) to the first end (-X side).

That is, in the first parallel line 21p1 forming the first current path, a first return current flows in a direction opposite to the current direction of the signal current due to the flow of the signal current in the signal line 10. In addition, in the second parallel line 22p2 forming the second current path, a second return current flows in a direction opposite to the current direction of the signal current, that is, the same direction as the first return current, due to the flow of the signal current in the signal line 10.

Here, both the first return current flowing through the first parallel line 21p1 and the second return current flowing through the second parallel line 22p2 flow in a direction opposite to the current direction of the signal current. Accordingly, the first return current and the second return current act to reduce the overall inductance of the variable inductor ID1 due to electromagnetic coupling (mutual induction) between the signal line 10 and the first parallel line 21p1 and electromagnetic coupling (mutual induction) between the signal line 10 and the second parallel line 22p2. It is assumed that an inductance of the signal line 10 is Ls_{low}, an inductance of the return path (first parallel line 21p1 and second parallel line 22p2) is Lg_{low}, and a mutual inductance between the signal line 10 and the return path is M_{low}. An overall inductance L_{low} of the variable inductor ID1 in the low-inductance mode is Ls_{low} + Lg_{low} - M_{low}.

As described above, in the high-inductance mode, the first electronic switch 41 and the second electronic switch 42 are set to the open state. Therefore, the above-described first current path is not formed in the first parallel line 21p1, and the above-described second current path is not formed in the second parallel line 22p2. Therefore, the first return current flowing through the first parallel line 21p1 becomes extremely small, and the second return current flowing through the second parallel line 22p2 becomes extremely small.

On the other hand, the end portion of the first intersecting line 22c1 on the front side (-Y side) is always connected to the first ground conductor 31 through the second connection pad P2 (see FIG. 5). In addition, as described above, the first end (-Y side) of the second intersecting line 22c2 is always connected to the second ground conductor 32. Therefore, a third current path through which the current can flow between the first end (-Y side) of the second intersecting line 22c2 and the end portion on the front side (-Y side) of the first intersecting line 22c1 is formed in advance in the first intersecting line 22c1, the third parallel line 22p3, and the second intersecting line 22c2. Therefore, in the high-inductance mode, a third return current flows from the first end (-Y side) of the second intersecting line 22c2 to the end portion on the front side (-Y side) of the first intersecting line 22c1 through the third parallel line 22p3 due to the signal current in the signal line 10.

Here, the third return current flows in a direction opposite to the current direction of the signal current in the signal line 10 in the third parallel line 22p3 parallel to the signal line 10. In addition, the second intersecting line 22c2, the third parallel line 22p3, and the first intersecting line 22c1 through which the third return current flows constitute a loop line that is looped in a U-shape to be convex toward a side opposite to the signal line 10 (+Y side). Therefore, the inductance of the return path can be increased compared with the configuration in the related art in which the return path (a path through which the third return current flows) does not constitute a loop line. As a result, it is possible to increase the overall inductance of the variable inductor ID1. It is assumed that an inductance of the signal line 10 is Ls_{high}, an inductance of the return path (the second intersecting line 22c2, the third parallel line 22p3, and the first intersecting line 22c1) is Lg_{high}, and a mutual inductance between the signal line 10 and the return path is M_{high}. An overall inductance L_{high} of the variable inductor ID1 in the high-inductance mode is Ls_{high} + Lg_{high} - M_{high}. Here, it is clear that Lg_{low} < Lg_{high} and M_{low} > M_{high} are satisfied, so that L_{high} > L_{low} is satisfied.

The principle in which the third return current acts to increase the inductance of the return path can be described as follows. That is, a magnetic field generated in a case in which the third return current flows through the second intersecting line 22c2, a magnetic field generated in a case in which the third return current flows through the third parallel line 22p3, and a magnetic field generated in a case in which the third return current flows through the first intersecting line 22c1 are all in the same direction (+Z direction) at the center O (see FIG. 4) of the loop line. Therefore, these magnetic fields strengthen each other. Therefore, it is possible to increase the magnetic field generated by the third return current and to increase the inductance of the return path, compared with the configuration in the related art in which the line through which the third return current flows does not constitute a loop line. In addition, by adjusting the height of the loop (that is, the position of the third parallel line 22p3 in the intersection direction Y and the lengths of the first intersecting line 22c1 and the second intersecting line 22c2), the value of the inductance of the return path can be significantly changed.

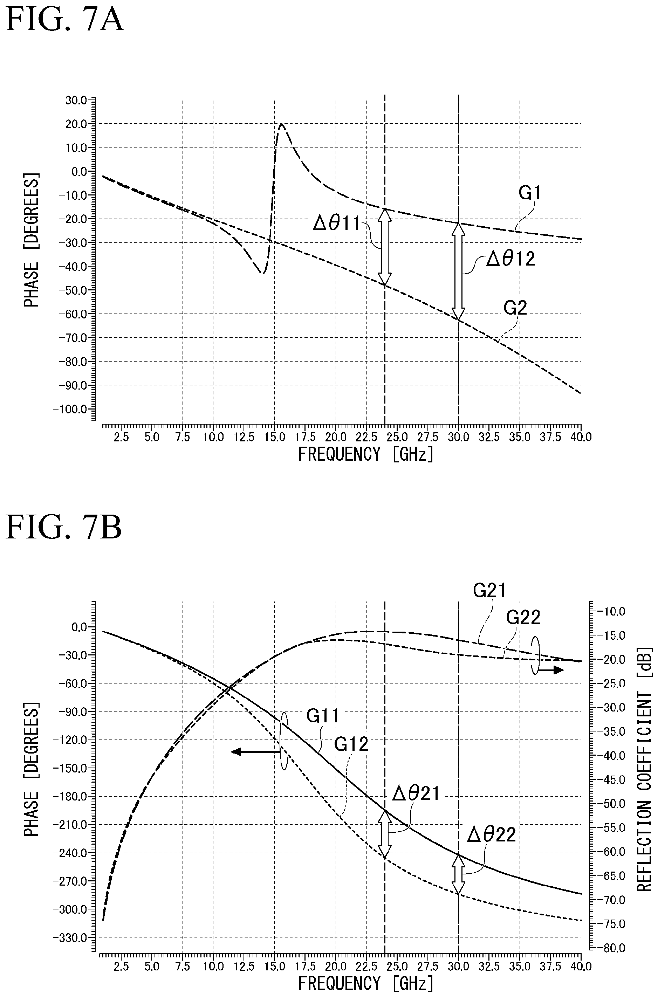

FIGS. 7A and 7B are diagrams showing simulation results of the first phase shift circuit and the second phase shift circuit in the first embodiment of the present invention. The simulation result shown in FIG. 7A shows the passing phase characteristics of the first phase shift circuit 100, and the simulation result shown in FIG. 7B shows the reflection coefficient and the passing phase characteristics of the second phase shift circuit 200. In the graphs shown in FIGS. 7A and 7B, a horizontal axis represents a frequency [GHz], and a vertical axis on a left side of a paper surface represents a phase [degrees]. In the graph shown in FIG. 7B, the reflection coefficient [dB] is taken on a vertical axis on a right side of the paper surface in addition to the vertical axis on the left side of the paper surface.

In FIG. 7A, a curve denoted by a reference sign G1 is a curve showing the frequency characteristics of the phase of the first phase shift circuit 100 in a case in which the first phase shift circuit 100 is set to the low-latency mode. A curve denoted by a reference sign G2 is a curve showing the frequency characteristics of the phase of the first phase shift circuit 100 in a case in which the first phase shift circuit 100 is set to the high-latency mode.

With reference to FIG. 7A, it can be seen that the first phase shift circuit 100 has the frequency dependence in which the phase shift amount (an absolute value of the difference between the phase in the low-latency mode and the phase in the high-latency mode) increases as the frequency increases in a frequency band of at least 24 to 30 [GHz]. For example, it can be seen that a phase shift amount Δθ11 is approximately 32.3 [degrees] in a case in which the frequency is 24 [GHz], and a phase shift amount Δθ12 is approximately 40.8 [degrees] in a case in which the frequency is 30 [GHz].

In FIG. 7B, a curve denoted by a reference sign G11 is a curve showing the frequency characteristics of the phase of the second phase shift circuit 200 in a case in which the second phase shift circuit 200 is set to the low-latency mode. A curve denoted by a reference sign G12 is a curve showing the frequency characteristics of the phase of the second phase shift circuit 200 in a case in which the second phase shift circuit 200 is set to the high-latency mode. In addition, a curve denoted by a reference sign G21 is a curve showing the frequency characteristics of the reflection coefficient of the second phase shift circuit 200 in a case in which the second phase shift circuit 200 is set to the low-latency mode. A curve denoted by a reference sign G22 is a curve showing the frequency characteristics of the reflection coefficient of the second phase shift circuit 200 in a case in which the second phase shift circuit 200 is set to the high-latency mode.

With reference to FIG. 7B, it can be seen that the second phase shift circuit 200 has the frequency dependence in which the phase shift amount (an absolute value of a difference between a first phase θ_{L} in the low-latency mode and a second phase θ_{II} in the high-latency mode) decreases as the frequency increases in a frequency band of at least 24 to 30 [GHz]. For example, it can be seen that a phase shift amount Δθ21 is approximately 50.97 [degrees] in a case in which the frequency is 24 [GHz], and a phase shift amount Δθ22 is approximately 41.42 [degrees] in a case in which the frequency is 30 [GHz].

As shown in FIG. 1, the digital phase shifter PS1 has a configuration in which the first phase shift circuit 100 and the second phase shift circuit 200 are cascade-connected. Accordingly, the phase shift amount of the digital phase shifter PS1 is the sum of the phase shift amount of the first phase shift circuit 100 and the phase shift amount of the second phase shift circuit 200. Specifically, the phase shift amount of the digital phase shifter PS1 is approximately 83.27 [degrees] in a case in which the frequency is 24 [GHz], and is approximately 82.22 [degrees] in a case in which the frequency is 30 [GHz].

As shown in FIG. 7A, a difference in the phase difference (|Δθ11 - Δθ12|) of the first phase shift circuit 100 in the frequency band of 24 to 30 [GHz] is approximately 8.5 [degrees]. On the other hand, the difference in the phase difference of the digital phase shifter PS1 in the frequency band of 24 to 30 [GHz] is approximately 1.50 [degrees] (= 183.27 - 82.221 [degrees]).

That is, it can be seen that the frequency dependence of the phase shift amount of the first phase shift circuit 100 is relaxed by the configuration in which the second phase shift circuit 200 is cascade-connected to the first phase shift circuit 100.

With reference to FIG. 7B, the reflection coefficient of the second phase shift circuit 200 is equal to or less than approximately -15 [dB] regardless of whether the second phase shift circuit 200 is set to the low-latency mode or set to the high-latency mode. As a result, it can be seen that the second phase shift circuit 200 has good impedance matching.

As described above, the digital phase shifter PS1 of the present embodiment has a configuration in which a second phase shift circuit 200 having frequency dependence of a phase shift amount that allows the relaxation of frequency dependence of a phase shift amount in a first phase shift circuit 100 is cascade-connected to the first phase shift circuit 100 of which a phase shift amount has frequency dependence. Here, the first phase shift circuit 100 has the frequency dependence in which the phase shift amount increases as a frequency increases, and the second phase shift circuit 200 has the frequency dependence in which the phase shift amount decreases as a frequency increases.

The second phase shift circuit 200 includes a first circuit 210 connected between a first port P200 and a second port P210, a second circuit 220 connected in parallel to the first circuit 210, and a third circuit 230 connected between the second circuit 220 and a common return line LN0. At least one of the first circuit 210, the second circuit 220, or the third circuit 230 includes a variable inductor ID1. In the present embodiment, the third circuit 230 includes a variable inductor 232 (variable inductor ID1).

The variable inductor ID1 includes the signal line 10, the first line 21 including the first parallel line 21p1 extending parallel to the signal line 10, the second line 22 including the second parallel line 22p2 extending parallel to the signal line 10, the first intersecting line 22c1 extending away from the signal line 10 in the intersection direction intersecting the longitudinal direction of the signal line 10 from the first end portion of the second parallel line 22p2, the third parallel line 22p3 extending parallel to the signal line 10 from the first end portion of the first intersecting line 22c1, and the second intersecting line 22c2 extending toward the signal line 10 in the intersection direction from the first end portion of the third parallel line, the first ground conductor 31 electrically connected to the first end portion of the first parallel line 21p1 and the first end portion of the second parallel line 22p2, the second ground conductor 32 connected to the first end portion of the second line 22, the first electronic switch 41 provided between the second end portion of the first parallel line 21p1 and the second ground conductor 32, and the second electronic switch 42 provided between the second end portion of the second parallel line 22p2 and the second ground conductor 32, and the signal line 10 is located between the first parallel line 21p1 and the second parallel line 22p2.

With the digital phase shifter PS1 having such a configuration, the frequency dependence of the first phase shift circuit 100 (the frequency dependence in which the phase shift amount increases as the frequency increases) can be relaxed by the frequency dependence of the second phase shift circuit 200 (the frequency dependence in which the phase shift amount decreases as the frequency increases).

### [Second Embodiment]

### <Digital Phase Shifter>

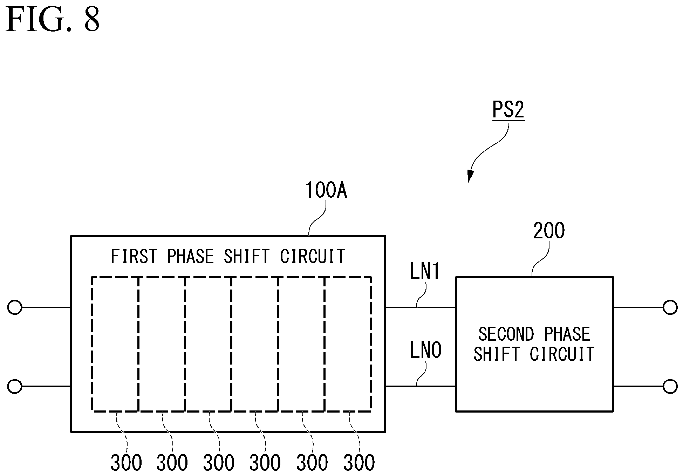

FIG. 8 is a block diagram showing a configuration of a digital phase shifter according to a second embodiment of the present invention. As shown in FIG. 8, a digital phase shifter PS2 of the present embodiment has a configuration in which the first phase shift circuit 100 of the digital phase shifter PS1 shown in FIG. 1 is replaced with a first phase shift circuit 100A. The digital phase shifter PS2 receives a high-frequency signal such as microwaves, quasi-millimeter waves, or millimeter waves as an input and outputs a high-frequency signal shifted by a predetermined phase to the outside, as in the digital phase shifter PS1.

The first phase shift circuit 100A shifts the input high-frequency signal by a predetermined phase and outputs the shifted high-frequency signal, as in the first phase shift circuit 100 shown in FIG. 1. The first phase shift circuit 100A has a phase shift amount having frequency dependence. For example, the first phase shift circuit 100A has the frequency dependence in which the phase shift amount increases as the frequency increases. The digital phase shifter PS2 of the present embodiment relaxes the frequency dependence of the phase shift amount of the first phase shift circuit 100A by the second phase shift circuit 200.

The first phase shift circuit 100A includes a plurality of digital phase shift circuits 300 that are cascade-connected. In the example shown in FIG. 8, the first phase shift circuit 100A includes six digital phase shift circuits 300 that are cascade-connected. Hereinafter, the digital phase shift circuit 300 included in the first phase shift circuit 100A will be described in detail. Since the second phase shift circuit 200 has the same configuration as the configuration described with reference to FIG. 3, the description thereof will be omitted.

### <Digital Phase Shift Circuit>

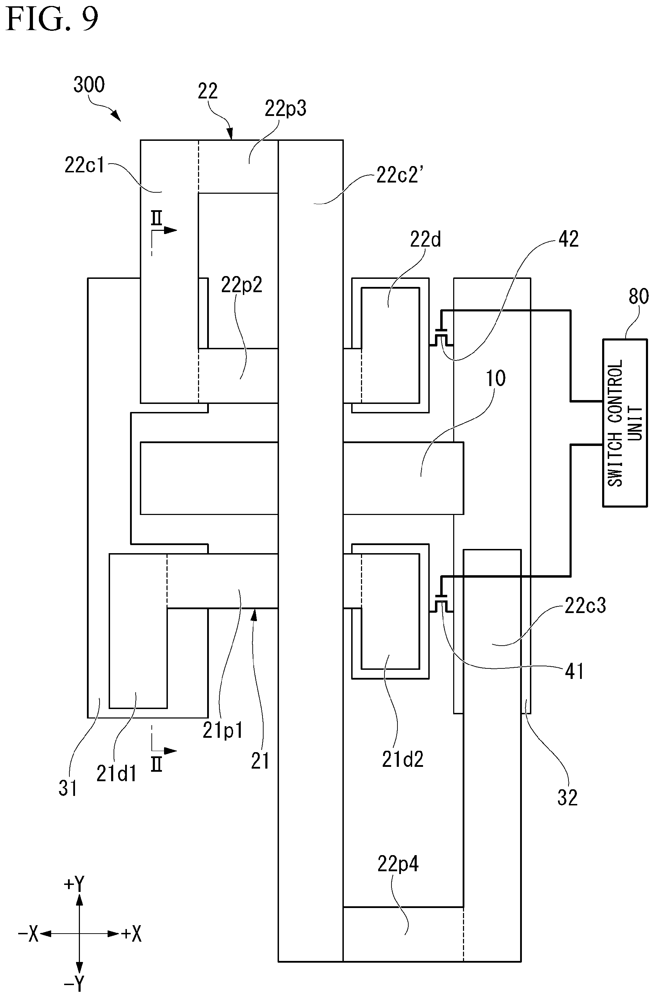

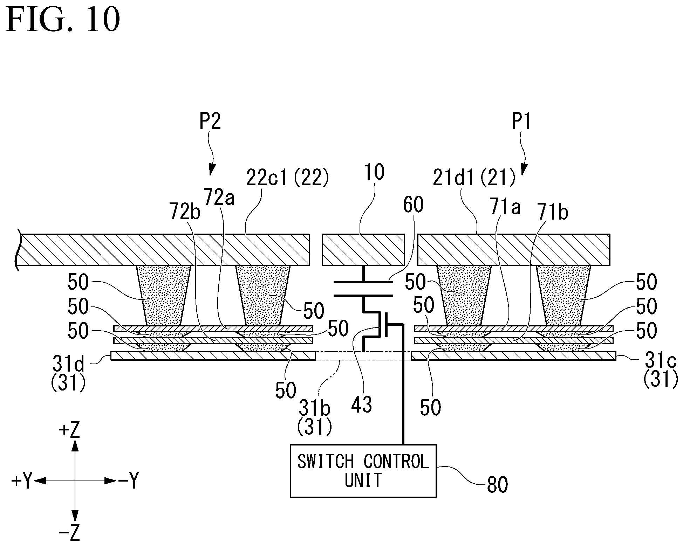

FIG. 9 is a plan view showing a main configuration of the digital phase shift circuit in the second embodiment of the present invention. FIG. 10 is a cross-sectional view taken along a line II-II in FIG. 9. The basic configuration of the digital phase shift circuit 300 shown in FIGS. 9 and 10 is the same as the basic configuration of the variable inductor ID1 described with reference to FIGS. 4 to 6. Therefore, the same configurations are denoted by the same reference signs, the description thereof will be omitted, and only a difference will be described.

As shown in FIG. 9, the digital phase shift circuit 300 and the variable inductor ID1 described with reference to FIGS. 4 to 6 have a different configuration of a second line 22. Specifically, the second line 22 includes the second parallel line 22p2, the first intersecting line 22c1, the third parallel line 22p3, a second intersecting line 22c2', a fourth parallel line 22p4, a third intersecting line 22c3, and the upper pad 22d.

The second intersecting line 22c2' is provided instead of the second intersecting line 22c2 shown in FIG. 4. In the present embodiment, the right end of the third parallel line 22p3 (that is, the first end (+X side) of the third parallel line 22p3) is located on the left side (-X side) with respect to the right end of the second parallel line 22p2 (that is, the second end (+X side) of the second parallel line 22p2). In addition, the second intersecting line 22c2' in the present embodiment is different from the second intersecting line 22c2 shown in FIG. 4, and extends to intersect the second parallel line 22p2, the signal line 10, and the first parallel line 21p1 in a plan view.

The second intersecting line 22c2' is located above the second parallel line 22p2, the signal line 10, and the first parallel line 21p1 such that the second intersecting line 22c2' does not come into contact with the second parallel line 22p2, the signal line 10, and the first parallel line 21p1. More specifically, the second intersecting line 22c2' is formed in another conductive layer that faces the conductive layer, in which the second parallel line 22p2, the signal line 10, and the first parallel line 21p1 are formed, with the insulating layer interposed therebetween. In addition, the second intersecting line 22c2' is located above the third parallel line 22p3, and the second end (+Y side) of the second intersecting line 22c2' and the right end (+X side) of the third parallel line 22p3 are electrically connected to each other through the conductor (not shown) (for example, a via). The second intersecting line 22c2' may be located below the second parallel line 22p2, the signal line 10, and the first parallel line 21p1. However, the configuration in which the second intersecting line 22c2' is located above the second parallel line 22p2, the signal line 10, and the first parallel line 21p1 is suitable from the viewpoint that the wiring can be easily thickened, and accordingly, the resistance value of the wiring can be easily lowered.

The fourth parallel line 22p4 and the third intersecting line 22c3 are located at the same positions as the second parallel line 22p2, the first intersecting line 22c1, and the third parallel line 22p3 in the up-down direction Z. That is, the fourth parallel line 22p4 and the third intersecting line 22c3 are formed in the same conductive layer as the second parallel line 22p2, the first intersecting line 22c1, and the third parallel line 22p3.

The fourth parallel line 22p4 is a linear strip-shaped conductor connected to a first end (-Y side) of the second intersecting line 22c2'. The fourth parallel line 22p4 is an elongated plate-shaped conductor having a constant width, a constant thickness, and a predetermined length. The fourth parallel line 22p4 extends parallel to the signal line 10 (in the longitudinal direction X) from the first end (-Y side) of the second intersecting line 22c2'. That is, the fourth parallel line 22p4 in the present embodiment extends toward the right side (+X side) from the first end (-Y side) of the second intersecting line 22c2'. Among the ends of the fourth parallel line 22p4, an end located on the +X side will be referred to as a first end (one end), and an end located on the -X side will be referred to as a second end (the other end). The first end (-Y side) of the second intersecting line 22c2' and the left end of the fourth parallel line 22p4 (that is, the second end (-X side) of the fourth parallel line 22p4) are electrically connected to each other through the conductor (not shown) (for example, a via).

The fourth parallel line 22p4 is provided at a position farther from the signal line 10 than the first parallel line 21p1 on the second side (-Y side) of the signal line 10. In other words, the fourth parallel line 22p4 is disposed such that the first parallel line 21p1 is located between the signal line 10 and the fourth parallel line 22p4 in the intersection direction Y. In addition, the right end of the fourth parallel line 22p4 (that is, the first end (+X side) of the fourth parallel line 22p4) is located to the right side (+X side) with respect to the long side of the upper pad 21d2 of the first line 21 on the right side (+X side).

The third intersecting line 22c3 is a linear strip-shaped conductor connected to the first end (+X side) of the fourth parallel line 22p4. The third intersecting line 22c3 is an elongated plate-shaped conductor having a constant width, a constant thickness, and a predetermined length. The third intersecting line 22c3 extends toward the signal line 10 in the intersection direction Y from the first end (+X side) of the fourth parallel line 22p4. That is, the third intersecting line 22c3 in the present embodiment extends toward the rear side (+Y side) from the first end (+X side) of the fourth parallel line 22p4. Among the ends of the third intersecting line 22c3, an end located on the +Y side will be referred to as a first end (one end), and an end located on the -Y side will be referred to as a second end (the other end).

In addition, the upper pad 21d2 and the third intersecting line 22c3 are disposed with a spacing in the longitudinal direction X. In addition, the first end (+Y side) of the third intersecting line 22c3 in the present embodiment is always electrically connected to the second ground conductor 32 through the conductor (not shown). In other words, one end of the second line 22 is always electrically connected to the second ground conductor 32 by a conductor (not shown).

In addition, as shown in FIG. 10, the digital phase shift circuit 300 includes a capacitor 60 and a third electronic switch 43. As shown in FIG. 10, the capacitor 60 is a parallel flat plate in which an upper electrode is connected to the signal line 10 and a lower electrode is connected to the first ground conductor 31 through the third electronic switch 43. The capacitor 60 has a capacitance Ca corresponding to the facing area of the parallel flat plate. That is, the capacitance Ca is a circuit constant provided between the signal line 10 and the first ground conductor 31.

As shown in FIG. 10, the third electronic switch 43 is a transistor that openably and closably connects the lower electrode of the capacitor 60 and the first ground conductor 31. The third electronic switch 43 is, for example, a MOS type FET, in which a drain terminal is connected to the lower electrode of the capacitor 60, a source terminal is connected to the first ground conductor 31, and a gate terminal is connected to the switch control unit 80.

The third electronic switch 43 switches the conduction state between the drain terminal and the source terminal between the open state and the closed state based on a gate signal input to the gate terminal from the switch control unit 80. That is, the third electronic switch 43 switches between the lower electrode of the capacitor 60 and the first ground conductor 31 between the conduction state or the cut-off state by the switch control unit 80. Specifically, the third electronic switch 43 switches between the lower electrode of the capacitor 60 and the first ground conductor 31 into the cut-off state in the low-latency mode, and switches between the lower electrode of the capacitor 60 and the first ground conductor 31 into the conduction state in the high-latency mode.

In the digital phase shift circuit 300, similarly to the variable inductor ID1 in the first embodiment, the first intersecting line 22c1, the third parallel line 22p3, and the second intersecting line 22c2' form a loop line that is looped in a U-shape to be convex toward the rear side (+Y side). In addition, in the digital phase shift circuit 300, the second intersecting line 22c2', the fourth parallel line 22p4, and the third intersecting line 22c3 form a loop line that is looped in a U-shape to be convex toward the front side (-Y side). That is, the return path (the line through which the third return current flows) in the high-latency mode includes two loop lines. Therefore, it is possible to further increase the magnetic field generated by the third return current, and to further increase the inductance of the return path (the inductance of the transmission system).

In addition, in the low-latency mode, since the third electronic switch 43 is set to the open state, the capacitor 60 is not connected between the signal line 10 and the first ground conductor 31. That is, the capacitance Ca of the capacitor 60 does not affect the high-frequency signal propagating through the signal line 10. On the other hand, in the high-latency mode, since the third electronic switch 43 is set to the closed state, the capacitor 60 is connected between the signal line 10 and the first ground conductor 31. Accordingly, in the high-latency mode, a propagation delay time T_{H} until the high-frequency signal propagates from the input end (left end) to the output end (right end) of the signal line 10 can be made longer.

As described above, in the digital phase shift circuit 300, in the high-latency mode, the inductance of the return path (the inductance of the transmission system) can be further increased, and the propagation delay time T_{H} can be further increased. As a result, in the digital phase shift circuit 300, the difference (phase shift amount) between the phase θ_{L} in the low-latency mode and the phase θ_{II} in the high-latency mode can be made larger.

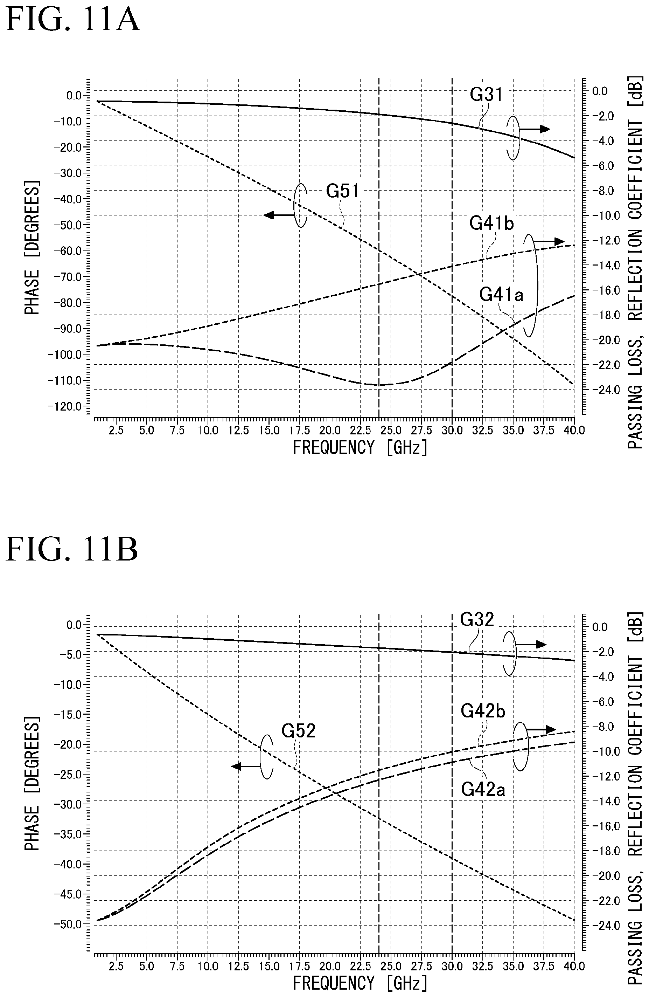

FIGS. 11A and 11B are diagrams showing simulation results of the first phase shift circuit in the second embodiment of the present invention. The simulation result shown in FIG. 11A shows the passing loss, the reflection coefficient, and the phase characteristics of the first phase shift circuit 100A in a case in which all the digital phase shift circuits 300 cascade-connected are set to the high-latency mode. The simulation result shown in FIG. 11B shows the passing loss, the reflection coefficient, and the phase characteristics of the first phase shift circuit 100A in a case in which all the digital phase shift circuits 300 cascade-connected are set to the low-latency mode. In the graphs shown in FIGS. 11A and 11B, a horizontal axis represents a frequency [GHz], a vertical axis on a left side of a paper surface represents a phase [degrees], and a vertical axis on a right side of the paper surface represents a passing loss and a reflection coefficient [dB].

**In** FIGS. 11A and 11B, curves denoted by reference signs G31 and G32 are curves showing the frequency characteristics of the passing loss of the first phase shift circuit 100A. Curves denoted by reference signs G41a and G42a are curves showing the frequency characteristics of the reflection coefficient on the input side of the first phase shift circuit 100A, and curves denoted by reference signs G41b and G42b are curves showing the frequency characteristics of the reflection coefficient on the output side of the first phase shift circuit 100A. Curves denoted by reference signs G51 and G52 are curves showing the frequency characteristics of the phase of the first phase shift circuit 100A.

With reference to FIGS. 11A and 11B, the first phase shift circuit 100A has the frequency dependence in which the phase shift amount (an absolute value of the difference between the phase in the low-latency mode and the phase in the high-latency mode) increases as the frequency increases in a frequency band of at least 24 to 30 [GHz]. For example, the phase shift amount is approximately 27.3 [degrees] in a case in which the frequency is 24 [GHz], and the phase shift amount is approximately 38.35 [degrees] in a case in which the frequency is 30 [GHz].

As described with reference to FIG. 7B, in the second phase shift circuit 200, the phase shift amount Δθ21 is approximately 50.97 [degrees] in a case in which the frequency is 24 [GHz], and the phase shift amount Δθ22 is approximately 41.42 [degrees] in a case in which the frequency is 30 [GHz]. As shown in FIG. 8, the digital phase shifter PS2 has a configuration in which the first phase shift circuit 100A and the second phase shift circuit 200 are cascade-connected. Accordingly, the phase shift amount of the digital phase shifter PS2 is the sum of the phase shift amount of the first phase shift circuit 100A and the phase shift amount of the second phase shift circuit 200. Specifically, the phase shift amount of the digital phase shifter PS2 is approximately 78.27 [degrees] in a case in which the frequency is 24 [GHz], and is approximately 79.77 [degrees] in a case in which the frequency is 30 [GHz].

As described above, the difference in the phase difference of the first phase shift circuit 100A in the frequency band of 24 to 30 [GHz] is approximately 11 [degrees] (= 127.3 - 38.351 [degrees]). On the other hand, the difference in the phase difference of the digital phase shifter PS2 in the frequency band of 24 to 30 [GHz] is approximately 1.50 [degrees] (= 178.27 - 79.771 [degrees]). That is, it can be seen that the frequency dependence of the phase shift amount of the first phase shift circuit 100A is relaxed by the configuration in which the second phase shift circuit 200 is cascade-connected to the first phase shift circuit 100A.

As described above, the digital phase shifter PS2 of the present embodiment has a configuration in which a second phase shift circuit 200 having frequency dependence of a phase shift amount that allows the relaxation of frequency dependence of a phase shift amount in a first phase shift circuit 100A is cascade-connected to the first phase shift circuit 100A having the frequency dependence of the phase shift amount. Here, the first phase shift circuit 100A is a circuit in which a plurality of digital phase shift circuits 300 having the configurations shown in FIGS. 9 and 10 are cascade-connected, and has the frequency dependence in which the phase shift amount increases as the frequency increases. The second phase shift circuit 200 has a configuration shown in FIG. 3 and has the frequency dependence in which the phase shift amount decreases as the frequency increases. With the digital phase shifter PS2 having such a configuration, the frequency dependence of the first phase shift circuit 100A (the frequency dependence in which the phase shift amount increases as the frequency increases) can be relaxed by the frequency dependence of the second phase shift circuit 200 (the frequency dependence in which the phase shift amount decreases as the frequency increases).

The digital phase shifter according to the embodiment of the present invention has been described above, but the present invention is not limited to the above-described embodiments and can be freely changed within the scope of the present invention. For example, in the digital phase shifter PS1 according to the first embodiment, the first phase shift circuit 100 and the second phase shift circuit 200 are cascade-connected, and in the digital phase shifter PS2 according to the second embodiment, the first phase shift circuit 100A and the second phase shift circuit 200 are cascade-connected. However, another circuit may be connected between the first phase shift circuit 100 or the first phase shift circuit 100A and the second phase shift circuit 200. In other words, the first phase shift circuit 100 or the first phase shift circuit 100A and the second phase shift circuit 200 may be cascade-connected to each other via another circuit.

In addition, in the first and second embodiments described above, the first phase shift circuits 100 and 100A have the frequency dependence in which the phase shift amount increases as a frequency increases, and the second phase shift circuit 200 has the frequency dependence in which the phase shift amount decreases as a frequency increases. However, the first phase shift circuits 100 and 100A may have the frequency dependence in which the phase shift amount decreases as the frequency increases, or may have the frequency dependence in which the center of the frequency band has the largest phase shift amount and the phase shift amount decreases toward the upper end and the lower end of the frequency band. In a case in which the first phase shift circuits 100 and 100A have such frequency dependence, the second phase shift circuit 200 needs to be designed to have the phase shift amount that allows the relaxation of the frequency dependence of the first phase shift circuits 100 and 100A.

### [Modification Examples of First and Second Embodiments]

### <Another Configuration Example of Second Phase Shift Circuit>

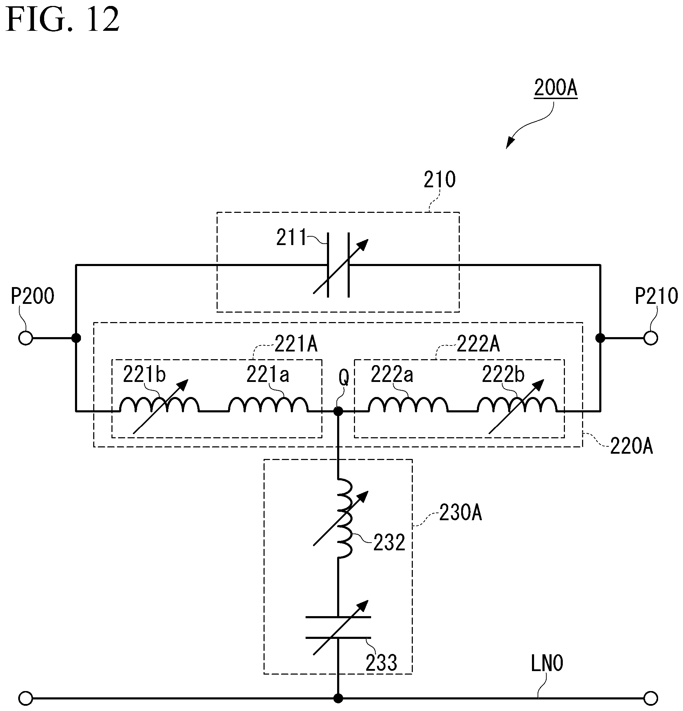

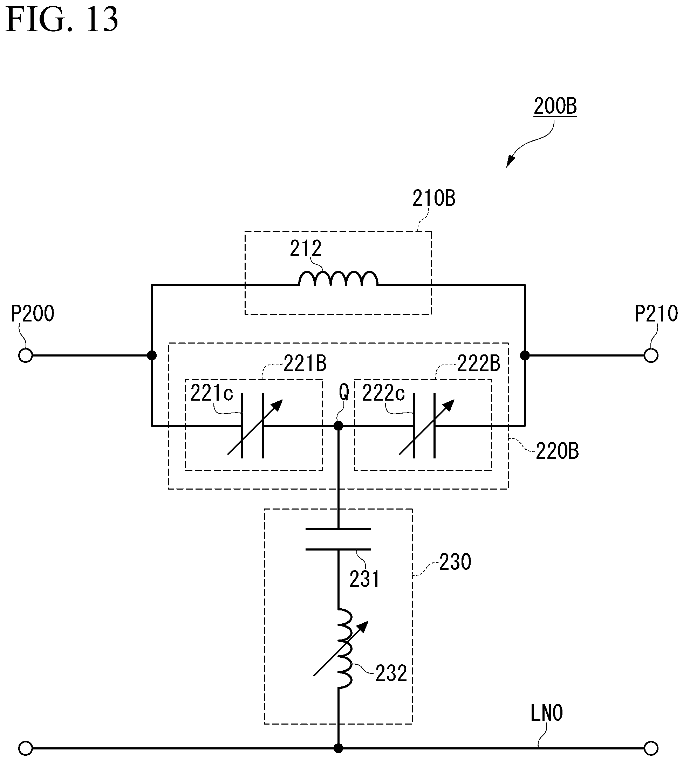

FIGS. 12 and 13 are circuit diagrams showing another configuration example of the second phase shift circuit in the first and second embodiments. In FIGS. 12 and 13, the configurations corresponding to the configurations shown in FIG. 3 are denoted by the same reference signs. The description of the same configurations denoted by the same reference signs will be omitted, and only the different points will be described.

The second phase shift circuit 200A shown in FIG. 12 has a configuration in which the second circuit 220 of the second phase shift circuit 200 shown in FIG. 3 is replaced with a second circuit 220A and the third circuit 230 is replaced with a third circuit 230A. The second phase shift circuit 200A achieves a larger phase shift amount Δθ than the second phase shift circuit 200 shown in FIG.1.

The second circuit 220A includes a first variable inductor circuit 221A and a second variable inductor circuit 222A that are connected in series. The first variable inductor circuit 221A is a circuit in which the fixed inductor 221a and a variable inductor 221b (first variable inductor) are connected in series, and the second variable inductor circuit 222A is a circuit in which the fixed inductor 222a and a variable inductor 222b (second variable inductor) are connected in series. That is, the first variable inductor circuit 221A has a configuration in which the variable inductor 221b is added to the first fixed inductor circuit 221 shown in FIG. 3, and the second variable inductor circuit 222A has a configuration in which the variable inductor 222b is added to the second fixed inductor circuit 222 shown in FIG. 3.

The variable inductor 221b has a first end (one end) connected to the first port P200, and has a second end (the other end) connected to a first end (one end) of the fixed inductor 221a. The fixed inductor 221a has the first end connected to a second end of the variable inductor 221b, and has a second end (the other end) connected to a first end (one end) of the fixed inductor 222a. The fixed inductor 222a has the first end connected to the second end of the fixed inductor 221a, and has a second end (the other end) connected to a first end (one end) of the variable inductor 222b. The variable inductor 222b has the first end connected to the second end of the fixed inductor 222a, and has a second end (the other end) connected to the second port P210. The connection relationship between the fixed inductor 221a and the variable inductor 221b in the first variable inductor circuit 221A and the connection relationship between the fixed inductor 222a and the variable inductor 222b in the second variable inductor circuit 222A may be interchanged.

Similar to the variable inductor 232 shown in FIG. 3, the variable inductor ID1 having the configuration shown in FIGS. 4 to 6 is used as the variable inductors 221b and 222b. That is, the variable inductors 221b and 222b can change the inductance by switching between the closed state and the open state of the first electronic switch 41 and the second electronic switch 42 shown in FIG. 4, as in the variable inductor 232 shown in FIG. 3. Similar to the variable capacitor 211 and the variable inductor 232, the variable inductors 221b and 222b are controlled by the control unit (not shown) in a case in which the phase shift amount of the second phase shift circuit 200A is changed.

The third circuit 230A includes the variable inductor 232 (third variable inductor) and the variable capacitor 233 that are connected in series, and is connected to the connection point Q between the first variable inductor circuit 221A and the second variable inductor circuit 222A that are provided in the second circuit 220A. The variable inductor 232 has a first end (one end) connected to the connection point Q, and has a second end (the other end) connected to a first electrode (one electrode) of the variable capacitor 233. The variable capacitor 233 has the first electrode connected to the second end of the variable inductor 232, and has a second electrode (the other electrode) connected to the common return line LN0. That is, the third circuit 230A is obtained by replacing the capacitor 231 of the third circuit 230 shown in FIG. 3 with the variable capacitor 233 and changing the order of connection between the variable inductor 232 and the variable capacitor 233. Similar to the variable capacitor 211, the variable capacitor 233 is controlled by the control unit (not shown) in a case in which the phase shift amount of the second phase shift circuit 200 is changed.

In the above-described configuration, the control unit (not shown) controls the variable capacitors 211 and 233 and the variable inductors 221b, 222b, and 232 to change the magnitude of the capacitance of the variable capacitors 211 and 233 and the magnitude of the inductance of the variable inductors 221b, 222b, and 232. As a result, the phase shift amount of the second phase shift circuit 200A is changed.

The second phase shift circuit 200A shown in FIG. 12 includes the variable capacitor 233 of the third circuit 230A in addition to the variable capacitor 211 of the first circuit 210. In addition, the second phase shift circuit 200A includes the variable inductors 221b and 222b of the second circuit 220A in addition to the variable inductor 232 of the third circuit 230A. Therefore, the inductance of the variable inductors 221b, 222b, and 232 can be changed together with the capacitance of the variable capacitors 211 and 233. Therefore, the second phase shift circuit 200A can dynamically change the phase shift amount while having desired phase shift characteristics.

The second phase shift circuit 200B shown in FIG. 13 has a configuration in which the first circuit 210 of the second phase shift circuit 200 shown in FIG. 3 is replaced with a first circuit 210B and the second circuit 220 of the second phase shift circuit 200 is replaced with a second circuit 220B.

The first circuit 210B includes a fixed inductor 212. The fixed inductor 212 has a first end (one end) connected to the first port P200, and has a second end (the other end) connected to the second port P210. The second circuit 220B includes a first capacitor circuit 221B and a second capacitor circuit 222B that are connected in series. The first capacitor circuit 221B includes a variable capacitor 221c (first variable capacitor), and the second capacitor circuit 222B includes a variable capacitor 222c (second variable capacitor). The variable capacitor 221c has a first electrode (one electrode) connected to the first port P200, and has a second electrode (the other electrode) connected to the first electrode (one electrode) of the variable capacitor 222c. The variable capacitor 222c has the first electrode connected to the second electrode of the variable capacitor 221c, and has the second electrode (the other electrode) connected to the second port P210.

In the above-described configuration, the control unit (not shown) controls the variable capacitors 221c and 222c and the variable inductor 232 to change the magnitude of the capacitance of the variable capacitors 221c and 222c and the magnitude of the inductance of the variable inductor 232. As a result, the phase shift amount of the second phase shift circuit 200B is changed. In the second phase shift circuit 200B having such a configuration as well, the phase shift amount can be dynamically changed while having desired phase shift characteristics.

The second phase shift circuits 200, 200A, and 200B shown in FIGS. 3, 12, and 13 may have the following configuration (modification example). The second phase shift circuit 200 shown in FIG. 3 may have a configuration in which a variable inductor is provided instead of the fixed inductor 221a of the second circuit 220, and a variable inductor is provided instead of the fixed inductor 222a. In addition, the second phase shift circuit 200 shown in FIG. 3 may have a configuration in which a variable capacitor is provided instead of the capacitor 231 of the third circuit 230. In addition, the second phase shift circuit 200 shown in FIG. 3 may have a configuration in which the capacitor 231 of the third circuit 230 is omitted.

The second phase shift circuit 200A shown in FIG. 12 may have a configuration in which the variable inductor 232 of the third circuit 230A is omitted. In addition, the second phase shift circuit 200A shown in FIG. 12 may have a configuration in which the fixed inductors 221a and 222a of the second circuit 220A are omitted.

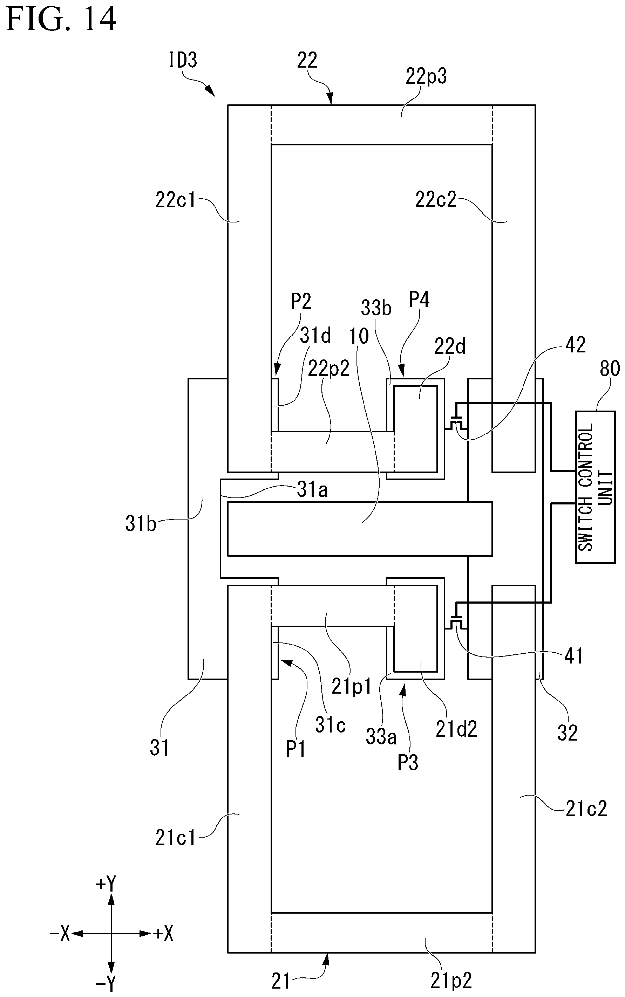

The second phase shift circuit 200B shown in FIG. 13 may have a configuration in which a variable inductor is provided instead of the fixed inductor 212 of the first circuit 210B. In addition, in the second phase shift circuit 200B shown in FIG. 13, the first circuit 210B may be a circuit in which the fixed inductor 212 and the variable inductor ID1 shown in FIGS. 4 to 6 are connected in series, or may be a circuit in which the fixed inductor 212 and a variable inductor ID2 described below are connected in series. Alternatively, the second phase shift circuit 200B shown in FIG. 13 may be a circuit in which the fixed inductor 212 and variable inductors ID3 to ID6 (details will be described below) shown in FIGS. 14 to 17 are connected in series. In addition, the second phase shift circuit 200B shown in FIG. 13 may have a configuration in which a variable capacitor is provided instead of the capacitor 231 of the third circuit 230. In addition, the second phase shift circuit 200B shown in FIG. 13 may have a configuration in which the capacitor 231 of the third circuit 230 is omitted.

In addition, among the elements (the capacitors and the inductors) constituting the second phase shift circuits 200, 200A, and 200B shown in FIGS. 3, 12, and 13 and the above-described modification examples, a target element in which the element value (the capacitance and the inductance) is fixed or made variable may be selected and determined as appropriate. However, in the second phase shift circuit 200A shown in FIG. 12 and the modification example thereof, for elements excluding the elements constituting the first variable inductor circuit 221A and the second variable inductor circuit 222A, whether to fix or to make variable the element value (the capacitance and the inductance) of the element may be selected and determined as appropriate.

### <Another Configuration Example of Inductor>

The variable inductors used as the variable inductor 232 shown in FIGS. 3, 12, and 13 and the variable inductors 221b and 222b shown in FIG. 12, and the variable inductors used in the above-described modification example are not limited to the variable inductor ID1 described with reference to FIGS. 4 to 6. For example, a configuration in which the capacitor 60 and the third electronic switch 43 shown in FIG. 10 are omitted from the digital phase shift circuit 300 described with reference to FIGS. 9 and 10 can be used as the variable inductor ID2 (not shown). In addition to this configuration, as the variable inductor 232 shown in FIGS. 3, 12, and 13 and the variable inductors 221b and 222b shown in FIG. 12, the configurations shown in FIGS. 14 to 17 can also be used.

FIG. 14 is a plan view showing another configuration example of the variable inductor. The variable inductor ID3 shown in FIG. 14 is a modification of the variable inductor ID1 described with reference to FIGS. 4 to 6. The variable inductor ID3 shown in FIG. 14 has a different configuration of the first line 21 from the variable inductor ID1 described using FIGS. 4 to 6. Specifically, the first line 21 of the variable inductor ID3 shown in FIG. 14 includes a fourth intersecting line 21c1, a fifth parallel line 21p2, and a fifth intersecting line 21c2, in addition to the first parallel line 21p1 and the upper pad 21d2. The upper pad 21d1 is omitted.

The fourth intersecting line 21c1 is a linear strip-shaped conductor connected to the first end (-X side) of the first parallel line 21p1. The fourth intersecting line 21c1 is an elongated plate-shaped conductor having a constant width, a constant thickness, and a predetermined length. The fourth intersecting line 21c1 extends away from the signal line 10 in the intersection direction Y from the first end (-X side) of the first parallel line 21p1. That is, the fourth intersecting line 21c1 in the present embodiment extends toward the front side (-Y side) from the first end (-X side) of the first parallel line 21p1. The end edge (+Y side) on the rear side of the fourth intersecting line 21c1 is located at substantially the same position as the first side edge (+Y side) of the first parallel line 21p1. Among the ends of the fourth intersecting line 21c1, an end located on the -Y side will be referred to as a first end (one end), and an end located on the +Y side will be referred to as a second end (the other end).

The fifth parallel line 21p2 is a linear strip-shaped conductor connected to the first end (-Y side) of the fourth intersecting line 21c1. The fifth parallel line 21p2 is an elongated plate-shaped conductor having a constant width, a constant thickness, and a predetermined length. The fifth parallel line 21p2 extends parallel to the signal line 10 (in the longitudinal direction X) from the first end portion (-Y side) of the fourth intersecting line 21c1. That is, the fifth parallel line 21p2 in the present embodiment extends toward the right side (+X side) from the first end portion (-Y side) of the fourth intersecting line 21c1. Among the ends of the fifth parallel line 21p2, an end located on the +X side will be referred to as a first end (one end), and an end located on the -X side will be referred to as a second end (the other end).

The fifth parallel line 21p2 is provided at a position farther from the signal line 10 than the first parallel line 21p1 on the second side (-Y side) of the signal line 10. In other words, the fifth parallel line 21p2 is disposed such that the first parallel line 21p1 is located between the signal line 10 and the fifth parallel line 21p2 in the intersection direction Y.

As shown in FIG. 14, in the intersection direction Y, a distance between the center line of the first parallel line 21p1 and the center line of the fifth parallel line 21p2 is the same as (or similar to) the distance d1 (see FIG. 4) between the center line of the second parallel line 22p2 and the center line of the third parallel line 22p3. The right end of the fifth parallel line 21p2 (that is, the first end (+X side) of the fifth parallel line 21p2) is located to the right side (+X side) of the long side of the upper pad 21d2 on the right side (+X side).

The fifth intersecting line 21c2 is a linear strip-shaped conductor connected to the first end (+X side) of the fifth parallel line 21p2. The fifth intersecting line 21c2 is an elongated plate-shaped conductor having a constant width, a constant thickness, and a predetermined length. The fifth intersecting line 21c2 extends toward the signal line 10 in the intersection direction Y from the first end (+X side) of the fifth parallel line 21p2. That is, the fifth intersecting line 21c2 in the present embodiment extends toward the rear side (+Y side) from the first end (+X side) of the fifth parallel line 21p2. Among the ends of the fifth intersecting line 21c2, an end located on the -Y side will be referred to as a first end (one end), and an end located on the +Y side will be referred to as a second end (the other end).

The second end edge (+Y side) of the fifth intersecting line 21c2 in the present embodiment is located at substantially the same position as the first short side (+Y side) of the upper pad 21d2 and the first side edge (+Y side) of the first parallel line 21p1 in the intersection direction Y. In addition, the upper pad 21d2 and the fifth intersecting line 21c2 are disposed with a spacing in the longitudinal direction X. In addition, a left side edge (-X side) of the fifth intersecting line in the present embodiment is located at substantially the same position as the right end edge (+X side) of the signal line 10 in the longitudinal direction X.

In addition, the second end (+Y side) of the fifth intersecting line 21c2 in the present embodiment is always electrically connected to the second ground conductor 32 through the conductor (not shown). In other words, one end of the first line 21 is always electrically connected to the second ground conductor 32 through the conductor (not shown).

The fourth intersecting line 21c1, the fifth parallel line 21p2, and the fifth intersecting line 21c2 described above constitute a loop line that is looped in a U-shape to be convex toward the front side (-Y side).

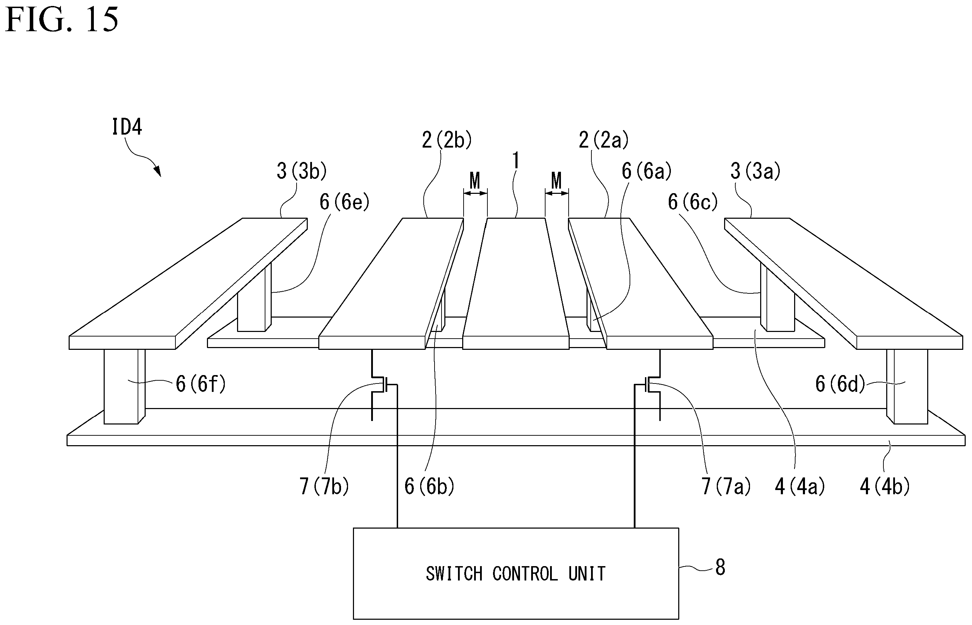

FIGS. 15 to 17 are perspective views showing another configuration example of the variable inductor. A variable inductor ID4 shown in FIG. 15 includes a signal line 1, two inner lines 2 (inner lines 2a and 2b), two outer lines 3 (outer lines 3a and 3b), two ground conductors 4 (ground conductors 4a and 4b), a plurality of connection conductors 6, two electronic switches 7 (electronic switches 7a and 7b), and a switch control unit 8.

The signal line 1 is a linear strip-shaped conductor extending in a predetermined direction. That is, the signal line 1 is an elongated plate-shaped conductor having a constant width, a constant thickness, and a predetermined length. In the example shown in FIG. 15, a signal current flows from the front side to the rear side in the signal line 1. The signal current may flow from the rear side to the front side of the signal line 1.

The inner line 2 is a linear strip-shaped conductor. That is, the inner line 2 is an elongated plate-shaped conductor having a constant width, a constant thickness, and a predetermined length. The inner line 2 extends in the same direction as the extending direction of the signal line 1. The inner line 2 is provided parallel to the signal line 1. The inner line 2a (first inner line) is disposed apart from the first side (one side) of the signal line 1 by a predetermined distance M, and the inner line 2b (second inner line) is disposed apart from the second side (the other side) of the signal line 1 by the predetermined distance M. The predetermined distance M is set to be less than 10 µm. The predetermined distance M is more preferably, for example, 2 µm or less, and it is desirable to bring the inner line 2 as close as possible to the signal line 1. For example, it is desirable to bring the inner line 2 close to the manufacturing limit or close to the vicinity of the manufacturing limit of the signal line 1.

The outer line 3 is a linear strip-shaped conductor provided at a position farther from the signal line 1 than the inner line 2. That is, the outer line 3 is an elongated plate-shaped conductor having a constant width, a constant thickness, and a predetermined length. The outer line 3 extends in the same direction as the extending direction of the signal line 1, similarly to the inner line 2. The outer line 3 is provided parallel to the signal line 1. The outer line 3a (first outer line) is provided at a position farther from the signal line 1 than the inner line 2a on the first side of the signal line 1, and the outer line 3b (second outer line) is provided at a position farther from the signal line 1 than the inner line 2b on the second side of the signal line 1.

The ground conductor 4 is a linear strip-shaped conductor that is disposed below the inner line 2 and the outer line 3 at a predetermined distance and that is provided to be orthogonal to the inner line 2 and the outer line 3. That is, the ground conductor 4 is an elongated plate-shaped conductor having a constant width, a constant thickness, and a predetermined length. The ground conductor 4a (first ground conductor) is provided on the first end (one end) side of each of the inner line 2a, the inner line 2b, the outer line 3a, and the outer line 3b, and is electrically connected to each first end of the inner line 2a, the inner line 2b, the outer line 3a, and the outer line 3b. The ground conductor 4b (second ground conductor) is provided on the second end (the other end) side of each of the inner line 2a, the inner line 2b, the outer line 3a, and the outer line 3b, and is electrically connected to each second end of the outer line 3a and the outer line 3b. The ground conductor 4b is disposed parallel to the ground conductor 4a.

The plurality of connection conductors 6 include at least connection conductors 6a to 6f. The connection conductor 6a electrically and mechanically connects the first end of the inner line 2a and the ground conductor 4a. The connection conductor 6b electrically and mechanically connects the first end of the inner line 2b and the ground conductor 4a. The connection conductor 6c electrically and mechanically connects the first end of the outer line 3a and the ground conductor 4a. The connection conductor 6d electrically and mechanically connects the second end of the outer line 3a and the ground conductor 4b. The connection conductor 6e electrically and mechanically connects the first end of the outer line 3b and the ground conductor 4a. The connection conductor 6f electrically and mechanically connects the second end of the outer line 3b and the ground conductor 4b.

The electronic switch 7 is, for example, a MOS type field-effect transistor (FET), and is controlled to be in a closed state or an open state based on a gate signal input to a gate terminal from the switch control unit 8. The closed state is a state in which the drain terminal and the source terminal are in conduction. The open state is a state in which the drain terminal and the source terminal are not conducting, and the electrical connection is cut off.

The electronic switch 7a (first electronic switch) is connected between the second end of the inner line 2a and the ground conductor 4b. Specifically, in the electronic switch 7a, the drain terminal is electrically connected to the second end of the inner line 2a, the source terminal is electrically connected to the ground conductor 4b, and the gate terminal is electrically connected to the switch control unit 8. The electronic switch 7a switches between a conduction state in which the second end of the inner line 2a and the ground conductor 4b are electrically connected to each other and a cut-off state in which the electrical connection thereof is cut off, under the control of the switch control unit 8. The size of the electronic switch 7a is, for example, equal to or greater than the width of the ground conductor 4b.

The electronic switch 7b (second electronic switch) is connected between the second end of the inner line 2b and the ground conductor 4b. Specifically, in the electronic switch 7b, the drain terminal is electrically connected to the second end of the inner line 2b, the source terminal is electrically connected to the ground conductor 4b, and the gate terminal is electrically connected to the switch control unit 8. The electronic switch 7b switches between a conduction state in which the second end of the inner line 2b and the ground conductor 4b are electrically connected to each other and a cut-off state in which the electrical connection thereof is cut off, under the control of the switch control unit 8. The size of the electronic switch 7b is, for example, equal to or greater than the width of the ground conductor 4b.

The switch control unit 8 is a control circuit that controls the electronic switch 7 (electronic switch 7a and electronic switch 7b). For example, the switch control unit 8 includes two output ports. The switch control unit 8 outputs an individual gate signal from each output port and supplies the individual gate signal to each gate terminal of the plurality of electronic switches 7, to individually control each of the plurality of electronic switches 7 to the open state or the closed state. The switch control unit 8 corresponds to the switch control unit 80 shown in FIGS. 4 and 9.

In the above-described configuration, in a case in which the electronic switch 7a and the electronic switch 7b are controlled to be in the closed state by the switch control unit 8, the variable inductor ID4 enters a low-inductance mode. On the other hand, in a case in which the electronic switch 7a and the electronic switch 7b are controlled to be in the open state by the switch control unit 8, the variable inductor ID4 enters a high-inductance mode.

In the low-inductance mode, the inductance of the variable inductor ID4 is reduced due to a return current flowing through the inner line 2 (inner lines 2a and 2b). On the other hand, in the high-inductance mode, the return current flows through the outer line 3 (outer lines 3a and 3b), and thus the inductance of the variable inductor ID4 increases compared with the low-inductance mode. As described above, the variable inductor ID4 shown in FIG. 15 can change the inductance by switching between the closed state and the open state of the electronic switches 7a and 7b.

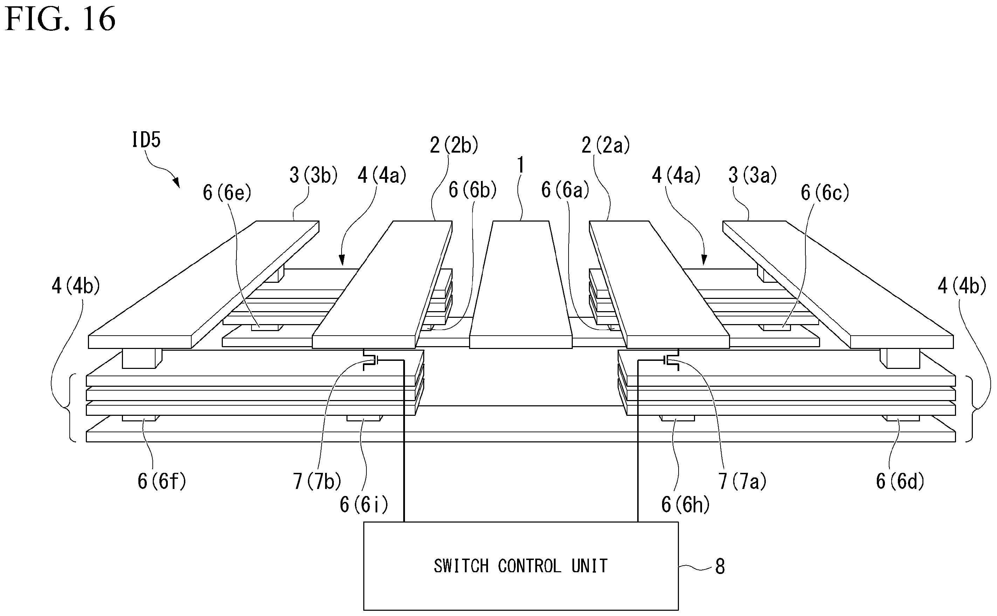

The variable inductor ID5 shown in FIG. 16 is different from the variable inductor ID4 shown in FIG. 15 in that the ground conductor 4a and the ground conductor 4b are formed in a multilayer structure between the outer line 3 and the inner line 2. The ground conductor 4a and the ground conductor 4b may be formed in a multilayer structure also between the inner line 2a and the inner line 2b.

The ground conductor 4a formed in a multilayer structure is connected to each other through a plurality of via holes (connection conductors 6a, 6b, 6c, and 6e). The ground conductor 4b formed in a multilayer structure is connected to each other through a plurality of via holes (connection conductors 6d, 6f, 6h, and 6i).

With this configuration, the resistance value of the ground conductor 4 between the outer line 3 and the inner line 2 can be reduced, and the loss of the high-frequency signal in the high-inductance mode can be reduced. Therefore, it is possible to reduce the unbalance in the signal amplitude between the high-inductance mode and the low-inductance mode. The variable inductor ID5 shown in FIG. 16 can also change the inductance of the variable inductor ID5 by switching between the closed state and the open state of the electronic switches 7a and 7b.

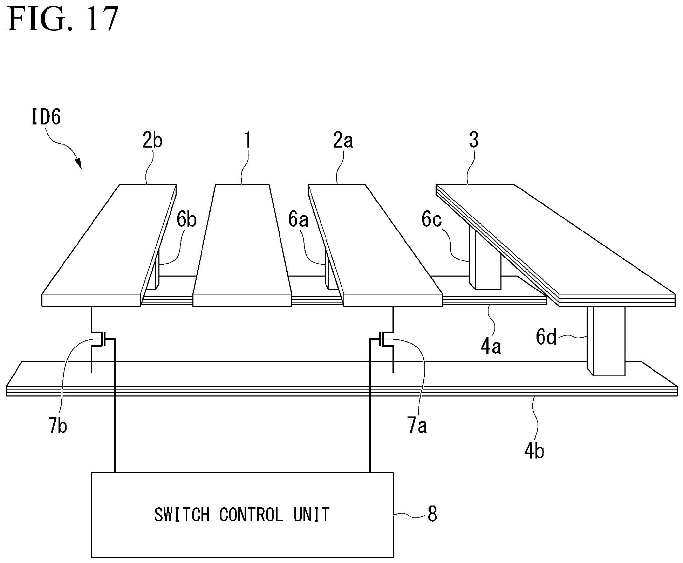

The variable inductor ID6 shown in FIG. 17 is different from the variable inductor ID4 shown in FIG. 15 in that the outer line 3b is omitted, the outer line 3 is formed to be wider than the width of the inner line 2, and the outer line 3, the ground conductor 4a, and the ground conductor 4b are formed in a multilayer structure. Only one of the multilayering of the ground conductors 4a and 4b, or the widening and multilayering of the outer line 3 may be performed as necessary, that is, only the multilayering of the ground conductors 4a and 4b may be performed, or only the widening and multilayering of the outer line 3 may be performed.

With such a configuration, it is possible to achieve a size reduction in the variable inductor ID6. Since the impedance of the ground conductors 4a and 4b can be reduced, the overall loss of the variable inductor ID6 can be reduced. In addition, since the impedance of the outer line 3 can be reduced, a difference between the loss of the variable inductor ID6 in the low-inductance mode and the loss of the variable inductor ID6 in the high-inductance mode can be reduced. The variable inductor ID6 shown in FIG. 17 can also change the inductance of the variable inductor ID6 by switching between the closed state and the open state of the electronic switches 7a and 7b.

### REFERENCE SIGNS LIST

1 Signal line
2, 2a, 2b Inner line
3, 3a, 3b Outer line
4a, 4b Ground conductor
7a, 7b Electronic switch
10 Signal line
21 First line
21c1 Fourth intersecting line
21c2 Fifth intersecting line
21p1 First parallel line
21p2 Fifth parallel line
22 Second line
22c1 First intersecting line
22c2, 22c2' Second intersecting line
22c3 Third intersecting line
22p2 Second parallel line
22p3 Third parallel line
22p4 Fourth parallel line
31 First ground conductor
32 Second ground conductor
41 First electronic switch
42 Second electronic switch
43 Third electronic switch
60 Capacitor
100, 100A First phase shift circuit
200, 200A, 200B Second phase shift circuit
210, 210B First circuit
211 Variable capacitor
212 Fixed inductor
220, 220A, 220B Second circuit
221A First variable inductor circuit
221a Fixed inductor
221b Variable inductor
221c Variable capacitor
222A Second variable inductor circuit
222a Fixed inductor
222b Variable inductor
222c Variable capacitor
230, 230A Third circuit
231 Fixed capacitor
232 Variable inductor
233 Variable capacitor
300 Digital phase shift circuit
ID1 to ID6 Variable inductor
LN0 Common return line
PS1, PS2 Digital phase shifter
P200 First port
P210 Second port
Q Connection point

## Claims

1. A digital phase shifter comprising:
a first phase shift circuit of which a phase shift amount has frequency dependence; and
a second phase shift circuit having frequency dependence of a phase shift amount that allows relaxation of the frequency dependence of the phase shift amount in the first phase shift circuit.

2. The digital phase shifter according to Claim 1,
wherein the first phase shift circuit has the frequency dependence in which the phase shift amount increases as a frequency increases, and
the second phase shift circuit has the frequency dependence in which the phase shift amount decreases as a frequency increases.

3. The digital phase shifter according to Claim 1 or 2,
wherein the second phase shift circuit includes
a first circuit connected between a first port and a second port,
a second circuit connected in parallel to the first circuit, and
a third circuit connected between the second circuit and a common return line, and
at least one of the first circuit, the second circuit, or the third circuit includes a variable inductor.

4. The digital phase shifter according to Claim 3,
wherein the variable inductor includes
a signal line,
a first line including a first parallel line extending parallel to the signal line,
a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, and a second intersecting line extending toward the signal line in the intersection direction from a first end portion of the third parallel line,
a first ground conductor electrically connected to a first end portion of the first parallel line and the first end portion of the second parallel line,
a second ground conductor connected to a first end portion of the second line,
a first electronic switch provided between a second end portion of the first parallel line and the second ground conductor, and
a second electronic switch provided between a second end portion of the second parallel line and the second ground conductor, and
the signal line is located between the first parallel line and the second parallel line.

5. The digital phase shifter according to Claim 4,
wherein the second intersecting line extends to intersect the second parallel line, the signal line, and the first parallel line in a plan view, and
the second line further includes a fourth parallel line extending parallel to the signal line from a first end portion of the second intersecting line, and a third intersecting line extending toward the signal line in the intersection direction from a first end portion of the fourth parallel line.

6. The digital phase shifter according to Claim 4,
wherein the first line further includes a fourth intersecting line extending away from the signal line in the intersection direction from the first end portion of the first parallel line, a fifth parallel line extending parallel to the signal line from a first end portion of the fourth intersecting line, and a fifth intersecting line extending toward the signal line in the intersection direction from a first end portion of the fifth parallel line.

7. The digital phase shifter according to Claim 3,
wherein the variable inductor includes
a signal line,
an inner line including a first inner line provided on a first side of the signal line and a second inner line provided on a second side of the signal line,
an outer line provided at a position farther from the signal line than the inner line on at least one of the first side or the second side of the signal line,
a first ground conductor connected to a first end portion of the first inner line, a first end portion of the second inner line, and a first end portion of the outer line,
a second ground conductor connected to a second end portion of the outer line, a first electronic switch provided between a second end portion of the first inner line and the second ground conductor, and
a second electronic switch provided between a second end portion of the second inner line and the second ground conductor.

8. The digital phase shifter according to any one of Claims 3 to 7,
wherein the first circuit includes a variable capacitor,
the second circuit includes a circuit in which a first fixed inductor and a second fixed inductor are connected in series, and
the third circuit includes a circuit in which the variable inductor and a fixed capacitor are connected in series, and is connected to a connection point between the first fixed inductor and the second fixed inductor.

9. The digital phase shifter according to any one of Claims 3 to 7,
wherein the first circuit includes a variable capacitor,
the second circuit includes a circuit in which a first variable inductor circuit in which a fixed inductor and a first variable inductor that is the variable inductor are connected in series and a second variable inductor circuit in which a fixed inductor and a second variable inductor that is the variable inductor are connected in series are connected in series, and
the third circuit includes a circuit in which a variable capacitor and a third variable inductor that is the variable inductor are connected in series, and is connected to a connection point between the first variable inductor circuit and the second variable inductor circuit.

10. The digital phase shifter according to any one of Claims 3 to 7,
wherein the first circuit includes a fixed inductor,
the second circuit includes a circuit in which a first variable capacitor and a second variable capacitor are connected in series, and
the third circuit includes a circuit in which the variable inductor and a fixed capacitor are connected in series, and is connected to a connection point between the first variable capacitor and the second variable capacitor.

11. The digital phase shifter according to any one of Claims 1 to 10,
wherein the first phase shift circuit includes a plurality of digital phase shift circuits that are cascade-connected,
each of the plurality of digital phase shift circuits includes
a signal line,
a first line including a first parallel line extending parallel to the signal line,
a second line including a second parallel line extending parallel to the signal line, a first intersecting line extending away from the signal line in an intersection direction intersecting a longitudinal direction of the signal line from a first end portion of the second parallel line, a third parallel line extending parallel to the signal line from a first end portion of the first intersecting line, a second intersecting line extending to intersect the second parallel line, the signal line, and the first parallel line in a plan view from a first end portion of the third parallel line, a fourth parallel line extending parallel to the signal line from a first end portion of the second intersecting line, and a third intersecting line extending toward the signal line in the intersection direction from a first end portion of the fourth parallel line,
a first ground conductor electrically connected to a first end portion of the first parallel line and the first end portion of the second parallel line,
a second ground conductor connected to a first end portion of the second line,
a capacitor connected to a first end portion of the signal line,
a first electronic switch provided between a second end portion of the first parallel line and the second ground conductor,
a second electronic switch provided between a second end portion of the second parallel line and the second ground conductor, and
a third electronic switch provided between the capacitor and the first ground conductor, and
the signal line is located between the first parallel line and the second parallel line.

12. The digital phase shifter according to Claim 11,
wherein all of the first electronic switch and the second electronic switch provided in the digital phase shift circuit of the first phase shift circuit are controlled to be in a closed state or to be in an open state.
